# EUROPEAN PATENT APPLICATION

(11) **EP 1 589 798 A1**
(43) Date of publication of application: **26.10.2005**
(21) Application number: 03815594.1
(22) Date of filing: 31.01.2003
(51) Int. Cl.: H05K 3/46, H01L 23/12, H01P 3/08

(54) **MULTILAYER PRINTED BOARD, ELECTRONIC APPARATUS, AND PACKAGING METHOD**

(71) Applicant: FUJITSU LIMITED, Kawasaki-shi, Kanagawa 211-8588 (JP)
(72) Inventor: KOYAMA, Hideki c/o FUJITSU LIMITED, Kawasaki-shi, Kanagawa 211-8588 (JP)
(74) Representative: Sunderland, James Harry
(86) International application number: PCT/JP2003/001010
(87) International publication number: WO 2004/068922

(57) **Abstract**

A multilayer printed board comprising a plurality of capacitive coupling layers (6) each consisting of a dielectric layer (4) and a power supply layer (3) and a ground layer (5) facing each other while sandwiching the dielectric layer (4), first vias (7) connecting between the power supply layers (3) included in the plurality of capacitive coupling layers (6), and second vias (8) connecting between the ground layers (5) included in the plurality of capacitive coupling layers (6).

## Description

### TECHNICAL FIELD

The present invention relates to a printed wiring board and an electronic apparatus including the printed wiring board.

### BACKGROUND ART

In a printed board on which a high-speed element is mounted, there are problems in that a high frequency current flows into a power supply layer and a ground layer, with the result that resonance occurs and an unnecessary electromagnetic wave is emitted. Up to now, a configuration to which a circuit using a resistor and a magnetic material is added has been employed to suppress the resonance.

However, such a method is disadvantageous in takingmeasures for packaging in a narrow space. The use of the resistor and the magnetic material increases the number of parts.

Up to now, for resonance measures or noise measures, high-frequency connection is made between the power supply layer and the ground layer through a chip capacitor or the like and charges are supplied to the element.

However, in recent years, with increases in frequency and packaging density in a device, effects obtained by the above-mentioned measures have been reduced due to inductance components of patterns and vias for packaging. In order to prevent this, attention has been focused on a substrate in which flat pattern layers on a circuit board are assumed as electrodes to form a capacitor (buried capacitance board, briefly referred to as a BC board). In addition, it has been proposed to locate a signal layer including a signal line, which is sandwiched by two ground layers (for example, see Patent Document 1 below).

Note that general structures of a multilayer printed board, for example, a via connecting between printed boards, a through hole, a clearance hole for ensuring insulation between the via and the printed board, and the like are described in, for example, Patent Document 2 below.
[Patent Document 1] JP 2001-223449 A
[Patent Document 2] JP 05- 152763 A

### DISCLOSURE OF THE INVENTION

However, a capacitance of the capacitor of the currently-available buried capacitance board is insufficient. Therefore, there is a problem in that an impedance of about several tens of MHz becomes higher to reduce a bypass effect. Therefore, the following measure methods are expected.

According to a first measure, it is expected to improve a dielectric constant of a dielectric composing the capacitor. However, a material whose dielectric constant is improved is generally expensive. A high dielectric constant material is not easily available in many cases.

According to a second measure, it is expected to reduce a thickness of the dielectric composing the capacitor. However, when the dielectric is too thin, a withstand voltage between the power supply layer and the ground layer reduces and they are short-circuited at worst. In addition, when the dielectric is too thin, handling thereof is hard.

According to a third measure, it is expected to increase an area of the capacitor. This corresponds to an increase in area of the printed board or an increase in area of a capacitor portion in the printed board. However, because of a limitation of size of a device, the area of the capacitor portion in the printed board is limited in many cases.

The present invention has been made in view of such problems of the conventional technologies. That is, an object of the present invention is to improve characteristics of the buried capacitance board.

More specifically, an object of the present invention is to improve a capacitance of a capacitor in a packaging method using the buried capacitance board. Further, an object of the present invention is to suppress a board resonance phenomenon in a packaging method using the buried capacitance board.

In order to achieve the above-mentioned objects, the present invention adopts the following measures. That is, the present invention relates to a multilayer printed board, including:
a plurality of capacitive coupling layers, each of which includes a power supply layer and a ground layer which are opposed to each other and a dielectric layer which is sandwiched therebetween;
a first via that connects between the power supply layers included in the plurality of capacitive coupling layers; and
a second via that connects between the ground layers included in the plurality of capacitive coupling layers.

Therefore, according to the present invention, the plurality of capacitive coupling layers are provided, the power supply layers included in the respective capacitive coupling layers are connected with each other, and the ground layers included in the respective capacitive coupling layers are connected with each other. Thus, a capacitance of each of the capacitive coupling layers can be increased to reduce an impedance in a low frequency domain in which a frequency is low.

Preferably, in the multilayer printed board, a power supply via that connects a power supply terminal of an element with the power supply layers may be formed near a central axis passing through a substantially central portion of a flat region of each of the capacitive coupling layers.

Alternatively, the present invention may relate to a multilayer printed board, including:
a capacitive coupling layer that includes a power supply layer and a ground layer which are opposed to each other and a dielectric layer which is sandwiched therebetween;
an element layer on which an element to which power is supplied from the power supply layer is mounted; and
a via that is formed close to a central axis passing through substantially a central portion of a flat region of the capacitive coupling layer and connects a power supply terminal of the element with the power supply layer.

Therefore, the multilayer printed board of the present invention has a via which is located near the central axis passing through the substantially central portion of the flat region of the capacitive coupling layer. A power supply terminal of the element is connected with the power supply layer. The element is desirably an element having a high-speed operating frequency in multilayer printed board. A high frequency wave is supplied from the element to the power supply layer through the via. However, the via is formed near the central axis, so that resonance dependent on a size of the capacitive coupling layer can be reduced.

Preferably, the number of at least one of the first via and the second via is two or more. Therefore, when the number of at least one of the first via and the second via is set to two or more, resonance points of which the number increases with an increase in capacitance of the capacitive coupling layer can be shifted to a high frequency side.

Preferably, the power supply layer and the ground layer in each of the plurality of capacitive coupling layers may be laminated in the same arrangement order.

Preferably, the power supply layer and the ground layer in a first capacitive coupling layer of the plurality of capacitive coupling layers may be laminated in an arrangement order reverse to an arrangement order of those in a second capacitive coupling layer thereof. That is, the present invention has no limitations on the arrangement order of the power supply layer and the ground layer.

Preferably, the power supply layer and the ground layer may form a capacitive coupling layer over an entire region of the dielectric layer.

Preferably, the power supply layer and the ground layer may form a capacitive coupling layer in a partial region of the dielectric layer.

Preferably, a flat shape of at least one of the power supply layer and the ground layer may be substantially a regular polygon having sides whose number is equal to or larger than five.

Preferably, a flat shape of at least one of the power supply layer and the ground layer may be substantially a circle.

Preferably, a ratio of a longest distance to a shortest distance between a central portion and a peripheral portion of a flat shape of at least one of the power supply layer and the ground layer thereof is 1 to 1.41.

According to the present invention, any structure described above may be used for an electronic apparatus provided with a multilayer printed board.

As described above, according to the present invention, the characteristics of the capacitive coupling layer can be improved to shift the resonance point to a high frequency domain.

### BRIEF DESCRIPTION OF THE DRAWINGS

FIG. 1 is a perspective view showing a multilayer printed board according to a first embodiment mode of the present invention;
FIG. 2 is a front view showing the multilayer printed board according to the first embodiment mode of the present invention;
FIG. 3 is a front view showing an analytical model of a multilayer printed board according to Embodiment 1;
FIG. 4 is a plan view showing positions of a power supply pin of an LSI 1, power supply vias 7A and 7B, and ground vias 8, which are mounted on the multilayer printed board according to Embodiment 1;
FIG. 5 shows an impedance analytical result of a BC board 6 shown in FIG. 4;
FIG. 6 shows an impedance analytical result (1) in the case where the number of BC layers 6 is changed;
FIG. 7 shows an impedance analytical result (2) in the case where the number of BC layers 6 is changed;
FIG. 8 shows the position of the power supply pin of the LSI 1 (power supply via 7A) and the positions of the power supply vias 7B and the ground vias 8 in Embodiment 2;
FIG. 9 shows a frequency characteristic of an impedance of the BC layer 6 in Embodiment 2;
FIG. 10 shows the position of the power supply pin of the LSI 1 (power supply via 7A) and the positions of the power supply vias 7B and the ground vias 8 in Embodiment 3;
FIG. 11 shows a frequency characteristic of an impedance of the BC layer 6 in Embodiment 3;
FIG. 12 is a perspective view showing a multilayer printed board according to a modified example of the first embodiment mode;
FIG. 13 is a front view showing the multilayer printed board according to the modified example of the first embodiment mode;
FIG. 14 is a perspective view showing a multilayer printed board according to a second embodiment mode;
FIG. 15 is a front view showing the multilayer printed board according to the second embodiment mode;
FIG. 16 is an explanatory view of a natural resonance frequency of a printed board;
FIG. 17 shows a summary of Embodiment 4 of the present invention;
FIG. 18 shows superposition of results obtained by measurement in Embodiment 4;
FIG. 19 shows an analytical result (1) of a current distribution;
FIG. 20 shows an analytical result (2) of a current distribution;
FIG. 21 shows an analytical result (3) of a current distribution;
FIG. 22 shows an analytical result (4) of a current distribution;
FIG. 23 shows an analytical result (5) of a current distribution;
FIG. 24 shows an analytical result (6) of a current distribution;
FIG. 25 shows respective states of the BC layer 6 in the case where the power supply via 7 (power supply pin 17 of the LSI 1) is shifted from a central position in the direction of a side of a rectangle composing the BC layer;
FIG. 26 shows a result obtained by analyzing horizontal polarization of a radiation electric field strength with respect to the respective states shown in FIG. 25;
FIG. 27 shows a result obtained by analyzing vertical polarization of a radiation electric field strength with respect to the respective states shown in FIG. 25;
FIG. 28 shows respective states of the BC layer 6 in the case where the power supply via 7 (power supply pin 17 of the LSI 1) is shifted from the central position in a vertex direction of the rectangle composing the BC layer;
FIG. 29 shows a result obtained by analyzing horizontal polarization of a radiation electric field strength with respect to the respective states shown in FIG. 28;
FIG. 30 shows a result obtained by analyzing vertical polarization of a radiation electric field strength with respect to the states shown in FIG. 28;
FIG. 31 shows a multilayer printed board having the BC layer 6 with a rectangular shape of 25 mm square;
FIG. 32 shows a result (1) obtained by analyzing horizontal polarization of a radiation electric field strength with respect to the multilayer printed board shown in FIG. 31;
FIG. 33 shows a result (1) obtained by analyzing vertical polarization of a radiation electric field strength with respect to the multilayer printed board shown in FIG. 31;
FIG. 34 shows a result (2) obtained by analyzing horizontal polarization of a radiation electric field strength with respect to the multilayer printed board shown in FIG. 31;
FIG. 35 shows a result (2) obtained by analyzing vertical polarization of a radiation electric field strength with respect to the multilayer printed board shown in FIG. 31;
FIG. 36 is a perspective view showing a multilayer printed board according to a third embodiment mode of the present invention;
FIG. 37 is a front view showing the multilayer printed board according to the third embodiment mode of the present invention;
FIG. 38 shows comparison between the BC layer 16 in the third embodiment mode and the BC layer in the first embodiment mode or the second embodiment mode;
FIG. 39 shows impedance analytical results in the case where the power supply via 7 is located near a central axis of a rectangular BC layer of 50 mm square and in the case where the power supply via 7 is located near a central axis of a circular BC layer 16 having a diameter of 50 mm;
FIG. 40 shows BC layers each having a flat shape of a regular polygon such as a regular octagon, a regular hexadecagon, or a regular triacontakaidigon;
FIG. 41 shows frequency characteristics with respect to an impedance between the power supply layer and the ground layer in each of the BC layers each having a flat shape such as a square, the regular octagon, the regular hexadecagon, or the regular triacontakaidigon;
FIG. 42 shows an analytical result (1) of a current density in a rectangular BC layer at a vicinity of a resonance point;
FIG. 43 shows an analytical result (2) of a current density in the rectangular BC layer in the vicinity of the resonance point;
FIG. 44 shows a current distribution of a high frequency current in an octagonal BC layer;
FIG. 45 shows a current distribution of a high frequency current in a triacontakaidigonal BC layer;
FIG. 46 shows an analytical result of a radiation electric field strength in rectangular, regular octagonal, regular hexadecagonal, and regular triacontakaidigonal BC layers at the time of resonance;
FIG. 47 shows a structure of an electric apparatus 100 according to a fourth embodiment mode of the present invention;
FIG. 48 shows a shape of the BC layer according to a modified example of the first to third embodiment modes;
FIG. 49 shows a layer structure of an analytical model of a multilayer print according to the second and third embodiment modes; and
FIG. 50 shows observation points for the radiation electric field strength in the analytical mode of the multilayer print according to the second and third embodiment modes.

### BEST MODE FOR CARRYING OUT THE INVENTION

Hereinafter, preferred embodiment modes of the present invention will be described with reference to the drawings.

### «First Embodiment Mode»

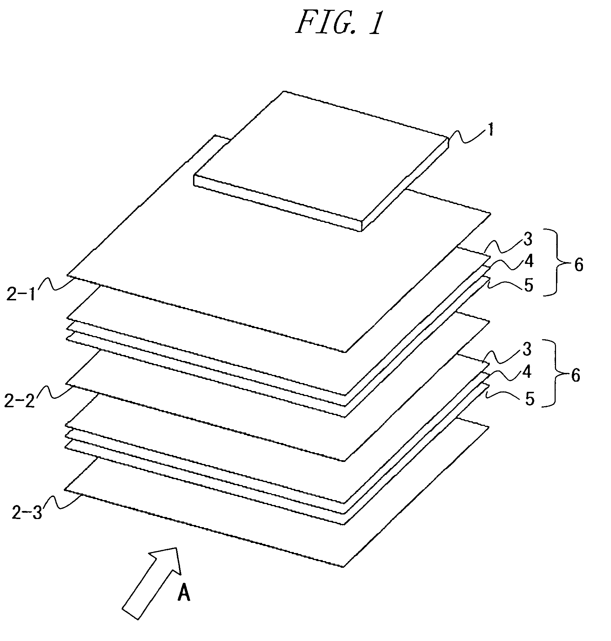

Hereinafter, a multilayer printed board according to a first embodiment mode of the present invention will be described with reference to FIG. 1 to FIG. 13.

### <Structure>

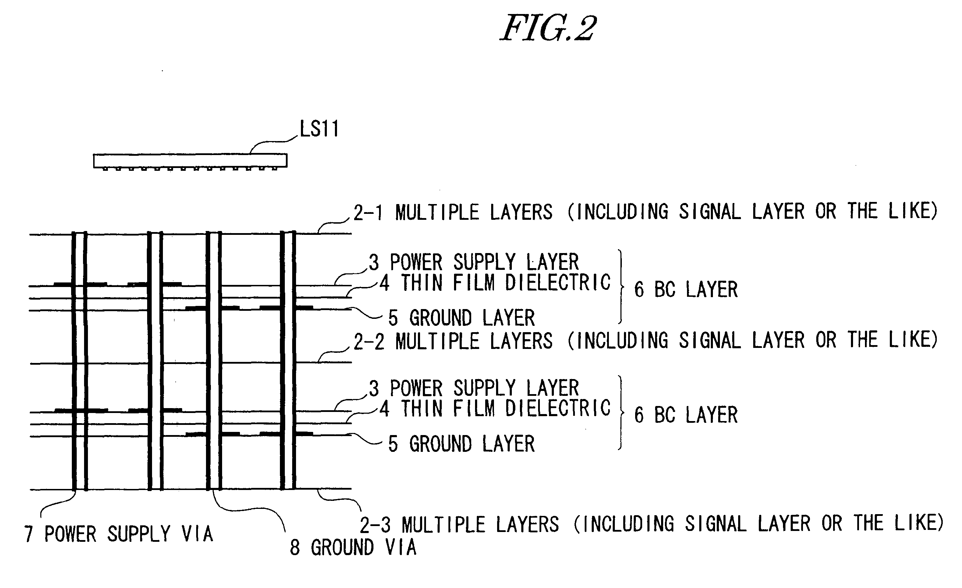

FIG. 1 is a perspective view showing an example of the multilayer printed board. FIG. 2 is a front view in the case where the multilayer printed board is viewed from a direction indicated by an arrow A in FIG. 1. As shown in FIG. 1 or FIG. 2, the multilayer printed board includes an element such as an LSI 1, printed boards 2-1, 2-2, and 2-3, each of which has a signal layer connected with the element, and BC layers 6 located between the printed boards 2-1 and 2-2 and the printed boards 2-2 and 2-3.

The printed boards 2-1, 2-2, 2-3, etc. each are composed of a single or plural printed boards. In the case of plural items, they are referred to as multiple layers 2-1, 2-2, 2-3, etc. In general, each of the printed boards 2-1, 2-2, 2-3, etc. includes a conductive layer (this is referred to as the signal layer) connected with the element such as the LSI 1.

The BC layers 6 each are composed of a power supply layer 3, a thin film dielectric 4, and a ground layer 6.

The power supply layer 3 is connected with a power supply located outside the multilayer printed board and used to supply power to the element mounted on the multilayer printed board. The power supply layer 3 is formed from a metallic thin film formed into a rectangular sheet. The metallic thin film is also referred to as a flat pattern layer. A copper thin film is generally used as a metallic film composing the power supply layer 3. Note that a metal such as aluminum, silver, platinum, and gold may be used if necessary.

The ground layer 5 is connected with an earth located outside the multilayer printed board and used as a layer for grounding the element mounted on the multilayer printed board. As in the case of the power supply layer 3, the ground layer 5 is formed from a metallic thin film made of copper or the like. The ground layer is also formed into a rectangular sheet and referred to as a flat pattern layer.

The thin film dielectric 4 is a dielectric layer inserted between the power supply layer 3 and the ground layer 5. The thin film dielectric 4 is used to increase a dielectric constant of a portion sandwiched between the power supply layer 3 and the ground layer 5 to improve a function as a capacitor. Such a board which is composed of the power supply layer 3, the thin film dielectric 4 , and the ground layer 5 is known as a buried capacitance board (or a BC board).

In this embodiment mode, for example, polyimide, Fr-4 (glass epoxy), or ceramic can be used for the thin film dielectric 4.

The multilayer printed board according to this embodiment mode has the plurality of BC layers 6 (two BC layers 6 are shown in FIG. 1 and FIG. 2).

As shown in FIG. 2, the power supply layers 3 included in the respective BC layers 6 are connected with each other through a power supply via 7. The power supply via 7 passes through the uppermost printed board 2-1 including the signal layer and is connected with a power supply pin of the LSI 1.

In general, when the via is formed, a hole is formed in the printed board (metallic thin film and the dielectric which is its lower layer) and an inner wall of the hole is coated with a metal. The via is used to connect, for example, between the printed board 2-1 and another printed board, between the printed board 2-1 and the power supply layer 3, or between the printed board 2-1 and the ground layer 5. The LSI 1 is located on the printed board 2-1 such that the power supply pin thereof is adj acent to the power supply via 7.

With respect to the printed boards 2-1, 2-2, and 2-3, the power supply layer 3, or the ground layer 5, which are not connected with the via, a hole having a shape larger than an outer diameter of the via (this is referred to as a clearance hole) is provided at a position in which the via is formed.

Therefore, an arbitrary layer included in the multilayer printed board can be connected with another layer by a combination of the via and the clearance hole (for example, see Patent Document 2 above). In this embodiment mode, an outer diameter (diameter of a conductor surface which is in contact with the hole of the printed board) of the power supply via 7 is 0.3 millimeters and an inner diameter of the clearance hole is about 0.9 millimeters.

As shown in FIG. 2, the ground layers 5 included in the respective BC layers 6 are connected with each other through a ground via 8 to ground the printed board 2-1, 2-2, or 2-3 and the element (such as the LSI 1).

When such a structure is used for the multilayer printed board according to this embodiment mode, the plurality of power supply layers 3 are connected with each other through the power supply via 7. In addition, in the multilayer printed board, the plurality of ground layers 5 are connected with each other through the ground via 8.

Thus, according to the multilayer printed board of the present invention, a sufficient capacitance is ensured in each of the BC boards 6. In this multilayer printed board, the power supply via 7 or the ground via 8 is not limited to a single via. That is, in the multilayer printed board of the present invention, a plurality of power supply vias 7 or a plurality of ground vias 8 are provided to improve a frequency characteristic of each of the BC boards 6.

### <Embodiment 1>

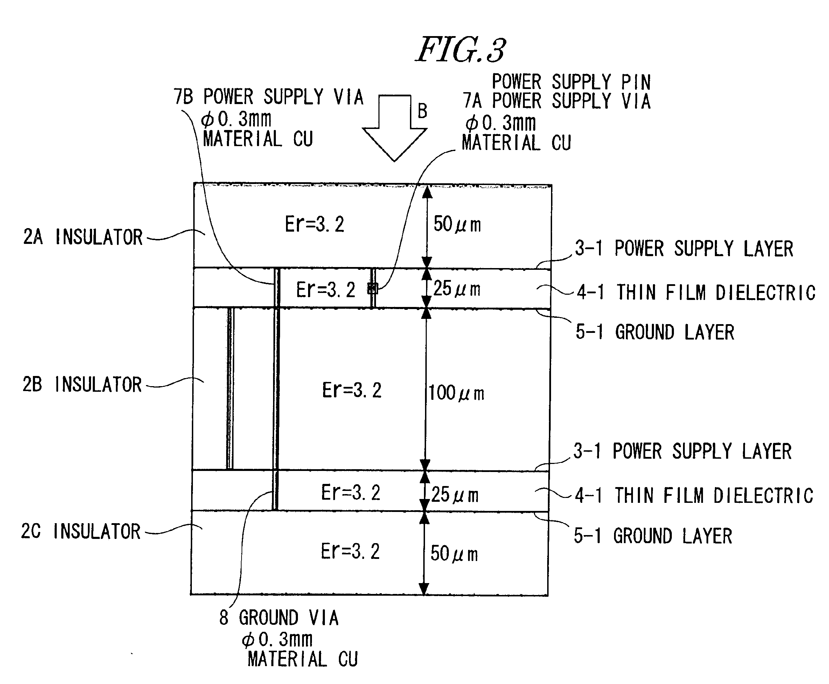

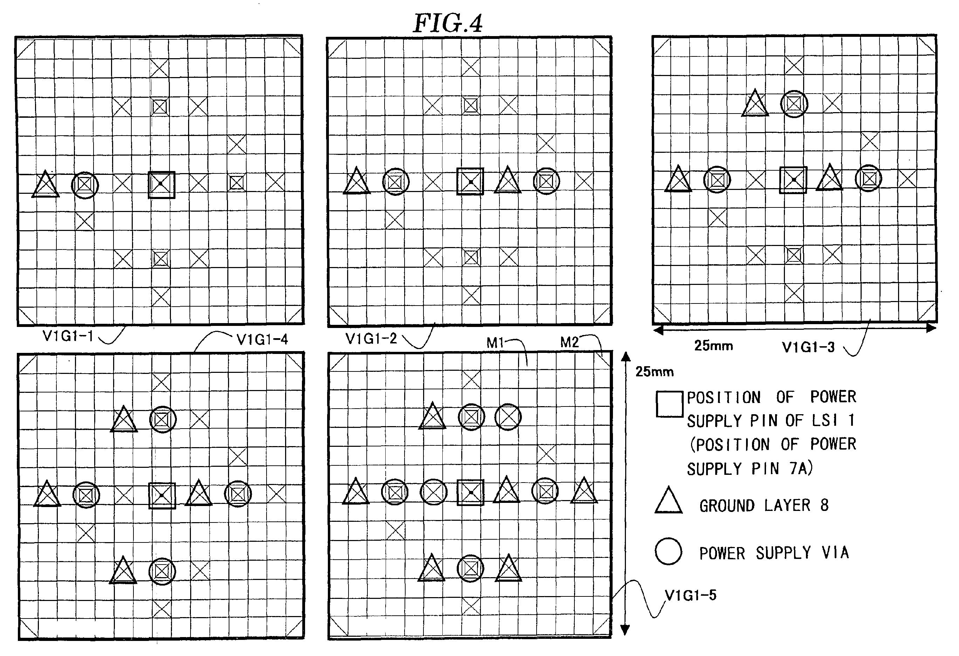

FIG. 3 and FIG. 4 show a structure of a multilayer printed board according to Embodiment 1 of the present invention. In this embodiment, numerical analytical results obtained by calculation of a modeled multilayer printed board are shown. FIG. 3 is a front view showing an analytical model in the case where the multilayer printed board is viewed from the front (for example, the direction indicated by the arrow A in FIG. 1) as in FIG. 2.

As shown in FIG. 3, the multilayer printed board includes an insulator 2A, a power supply layer 3-1, a thin film dielectric 4-1, a ground layer 5-1, an insulator 2B, a power supply layer 3-2, a thin filmdielectric 4-2, a ground layer 5-2, and an insulator 2C. Note that a signal layer is formed on an upper side of the insulator 2A or a lower side of the insulator 2B in an original multilayer printed board. In this embodiment, the influence of the signal layer is not considered for the simplification of the model.

Each of the insulators 2A and 2C is a dielectric which has a dielectric constant of 3.2 and a thickness of 50 micrometers. The insulator 2B is a dielectric which has a dielectric constant of 3.2 and a thickness of 100 micrometers. Each of the thin film dielectrics 4-1 and 4-2 is a dielectric which has a dielectric constant of 3.2 and a thickness of 25 micrometers. In FIG. 3, the dielectric constant is shown by symbol Er.

In Embodiment 1 of the present invention, the power supply layer 3-1 and the power supply layer 3-2 are connected with each other through a power supply via 7B. The ground layer 5-1 and the ground layer 5-2 are connected with each other through a ground via 8.

The power supply via 7B is a copper wire that connects the power supply layer 3-1 with the power supply layer 3-2 and has a diameter of 0.3 mm and conductivity of 5.977286 × 10⁷. The ground via 8 is a copper wire that connects the ground layer 5-1 with the ground layer 5-2 and has a diameter of 0.3 mm and conductivity of 5.977286 × 10⁷.

A clearance hole having a rectangular shape of 0.98 mm square is provided around each of the vias in layers which are not connected with the vias (power supply via 7B and ground via 8). Assume that air surrounds the multilayer printed board.

A virtual wave source (high frequency voltage source) is set between the power supply layer 3-1 and the ground layer 5-1 and a current flowing thereinto is calculated. At this time, a via that connects the wave source with the power supply layer 3-1 and the ground layer 5-1 is referred to as a power supply via 7A. The power supply via 7A is originally a via that connects the power supply pin of the LSI 1 with the power supply layer 3-1. However, in order to simply calculate an impedance between the power supply layer 3-1 and the ground layer 5-1, the wave source is set between the power supply layer 3-1 and the ground layer 5-1.

Here, a high frequency signal from the wave source is a trapezoid waveform whose rise time and fall time are each 500 ps, whose period is 100 MHz, and whose amplitude is 3.3 volts. In the analysis in this embodiment mode, various high frequency signals are inputted based on Fourier spectrum of the trapezoid waveform.

FIG. 4 is a plan view showing positions of the power supply pin of the LSI 1, the power supply vias 7A and 7B, and the ground via 8, which are mounted on the multilayer printed board (view in the case where the multilayer printed board is viewed from a direction indicated by an arrow B in FIG. 3). Note that FIG. 4 shows five cases (V1G1-1 to V1G1-5) in which the positions of the power supply via 7B and the ground via 8 are shifted.

In FIG. 4, any case of V1G1-1 to V1G1-5, the power supply pin of the LSI 1 is positioned in a central portion of the BC layer 6. As described above, in the multilayer printed board according to Embodiment 1, the power supply via 7A and the wave source are formed just below the power supply pin and between the power supply layer 3-1 and the ground layer 5-1 (see FIG. 3).

Each of five heavy rectangles indicated by V1G1-1 to V1G1-5 shows an existing region of the BC layer 6 and is a rectangle of 25 millimeters square.

In FIG. 4, mesh portions within each of the heavy rectangles indicated by V1G1-1 to V1G1-5 (such as M1 and M2) show element regions for numerical analysis. Note that the reason why each of the mesh portions in the four corners of each of the heavy rectangles (V1G1-1 to V1G1-5) is divided into two triangles as in the case of M2 is to ensure analytical precision.

V1G1-1 shows the case where the power supply via 7B and the ground via 8 are provided on the left side of the power supply pin of the LSI 1. Here, the left side is the left in the case where FIG. 4 is viewed from the front (hereinafter, the right side, the upper side, and the lower side are the same as above).

V1G1-2 shows the case where the power supply via 7B and the ground via 8 are further added on the right side of the power supply pin of the LSI 1 as compared with the case V1G1-1.

V1G1-3 shows the case where the power supply via 7B and the ground via 8 are further added on the upper side of the power supply pin of the LSI 1 as compared with the case V1G1-2.

V1G1-4 shows the case where the power supply via 7B and the ground via 8 are further added on the lower side of the power supply pin of the LSI 1 as compared with the case V1G1-3.

V1G1-5 shows the case where the two power supply vias 7B and the two ground vias 8 are further added as compared with the case V1G1-4.

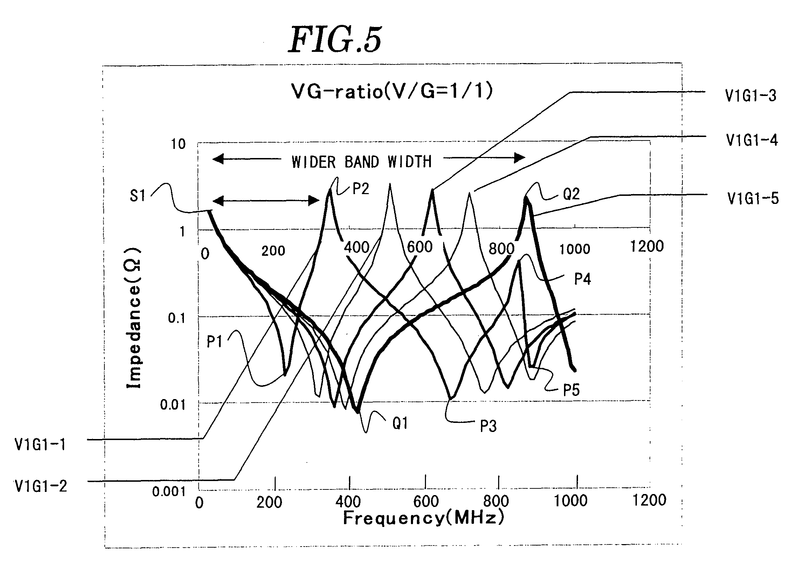

FIG. 5 shows an analytical result of an impedance of the BC board 6 (between the power supply layer 3 and the ground layer 5) in the five cases (V1G1-1 to V1G1-5) as shown in FIG. 4.

This analytical result is obtained by applying the electromagnetic analysis program ACCUFIELD (registered trademark) produced by FUJITSU LIMITED to the analytical model shown in FIG. 3 and FIG. 4. The ACCUFIELD (registered trademark) is an electromagnetic analysis program in which a piecewise sinusoidal moment method (also called a moment method) is combined with a distributed constant transmission line theory.

In this numerical analysis, a rectangular sheet of 25 mm square (conductor sheet having conductivity of 5.977286 × 10⁷) is provided for each of the power supply layers 3-1 and 3-2 and the ground layers 5-1 and 5-2 as shown in FIG. 3. Each rectangular sheet is divided into, for example, the mesh portions M1 and M2 shown in FIG. 4.

A high frequency power supply is set to a position of the wave source shown in FIG. 3 to obtain currents flowing through the respective mesh portions of each layer (each rectangular sheet) through the power supply vias 7A and 7B and the ground via 8.

As described above, in this embodiment, the currents are calculated by the electromagnetic analysis program run on a computer. In a structure in which the single BC layer 6 is used, the power supply layer is connected with the power supply via, and the ground layer is connected with the ground via, a result is obtained in which values obtained by analysis using the electromagnetic analysis program coincide with measured values.

FIG. 5 shows an impedance analytical result. In FIG. 5, the abscissa indicates a frequency and the ordinate indicates an impedance. Here, analytical results with respect to the respective analytical models V1G1-1 to V1G1-5 shown in FIG. 4 are shown using different graphs.

As shown in FIG. 5, each of the models V1G1-1 to V1G1-5 exhibits a W-shaped characteristic or a characteristic in which a plurality of V-shapes are connected with one another. For example, in the case of V1G1-1, the impedance characteristic starts from a left end point S1 and falls down to a lower right position P1 in a frequency range of about 50 MHz to 210 MHz.

Next, the impedance characteristic rises up to an upward position P2 in a frequency range of about 210 MHz to 350 MHz. Then, the impedance characteristic falls down to a downward position P3 in a frequency range of about 350 MHz to about 650 MHz. Then, the impedance characteristic rises up to P4 in a frequency range of about 650 MHz to 850 MHz.

In the impedance characteristic, each of peaks such as P1, P2, and P3 indicates a resonance point. In general, when an element is mounted on a board, it is desirable to avoid the use of an element having an operating frequency (for example, a clock cycle) close to a resonance frequency because this becomes a cause of malfunction or the like.

For example, in the multilayer printed board including the BC layer 6 having the impedance characteristic shown in FIG. 5, an element having a clock cycle of a range of S1 to P1, P2 to P3, or P4 to P5 is used. This is because each range is a capacitive domain in which the impedance reduces with an increase in frequency, so that characteristics are similar to one another.

For example, an element having a clock cycle of a range of P1 to P2 or P3 to P4 may be used. This is because each range is an inductive domain in which the impedance increases with an increase in frequency, so that characteristics are similar to one another. However, it is impossible to use an element having a frequency close to the peak such as P1, P2, P3, P4, P5, or P6 (particularly, a frequency in a domain slightly lower than P2 or P4). This is because the dependence of the impedance on the frequency is significant in the domain.

As is apparent from FIG. 5, the resonance point is shifted to a higher frequency domain (toward a higher frequency direction) with changing from V1G1-1 to V1G1-5. For example, a first resonance point in V1G1-5 is Q1. The resonance point Q1 corresponds to the resonance point P1 in V1G1-1.

In addition, a second resonance point in V1G1-5 is Q2. The resonance point Q2 corresponds to the resonance point P2 in V1G1-1. Therefore, a band of about 400 MHz is ensured up to the first resonance point Q1. A band of a frequency which exceeds 400 MHz (about 410 MHz to about 820 MHz) is ensured in a domain from the first resonance point Q1 to the next resonance point Q2.

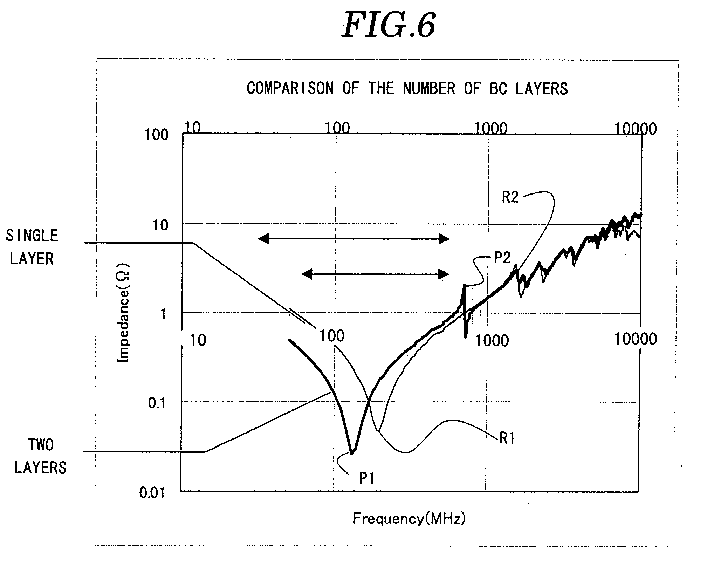

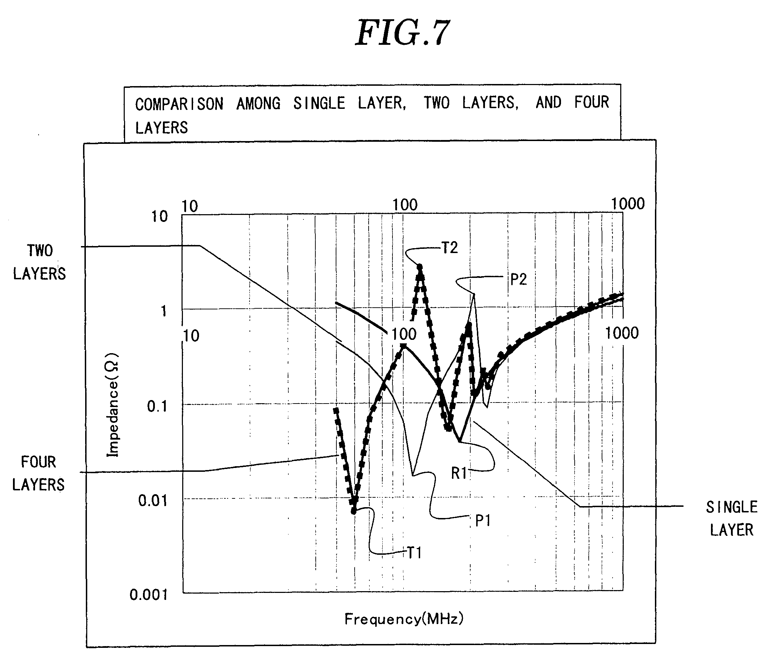

FIG. 6 and FIG. 7 show reference characteristics in the case where the number of BC layers 6 is changed. These reference characteristics are used to check characteristics caused due to changes in the number of BC layers 6. Therefore, as compared with the case of FIG. 5, an analytical condition is not identical and a resonance frequency is different.

FIG. 6 shows two impedance characteristics indicated by character strings "single layer" and "two layers". The "two layers" indicates an analytical result of an impedance characteristic in the case of the structure in Embodiment 1 (FIG. 3).

On the other hand, the "single layer" indicates an impedance characteristic in the case where one of the BC layers 6 is removed from the structure in Embodiment 1. In this case, the power supply via 7B for connecting between the power supply layers 3-1 and 3-2 and the ground via 8 for connecting between the ground layers 5-1 and 5-2 do not exist.

As shown in FIG. 6, in the case of the single layer, a first resonance point R1 occurs at about 200 MHz and a second resonance point R2 occurs at about 1500 MHz. On the other hand, in the case of the two layers, a first resonance point P1 occurs at about 150 MHz and the second resonance point P2 occurs at about 700 MHz.

As is apparent from FIG. 6, a capacitive impedance characteristic in the case of the two BC layers 6 reduces in a low frequency domain (about 50 MHz to about 150 MHz in FIG. 6) as compared with the case of the single BC layer. This indicates an increase in capacitance of each of the BC layers 6 serving as capacitors because the two power supply layers 3 are connected with each other through the power supply via 7B and the two ground layers 5 are connected with each other through the ground via 8.

In FIG. 6, the impedance characteristic in the case of the two BC layers 6 appears to increase in an inductance band which exceeds 200 MHz (vicinity of the resonance point R1 in the case of the single layer) as compared with the case of the single layer. This is because an apparent impedance in the case of the single layer is reduced by the presence of the resonance point R1 in the case of the single layer. Therefore, in a domain sufficiently apart from the resonance point R1 to a high frequency side, an inductive impedance in the case of the two layers is substantially equal to that in the case of the single layer.

On the other hand, as shown in FIG. 6, a band up to the resonance point in the case of the two layers is narrower than that in the case of the single layer. For example, the resonance point P1 in the case of the two layers is closer to a low frequency side than the resonance point R1 in the case of the single layer.

FIG. 7 shows a comparative result between the case of the single layer, the case of the two layers, and the case of four layers, for the purpose of reference. The "four layers" shows an analytical result in the case where the four BC layers 6 are used. Note that an analytical condition in FIG. 7 is different from that related to the analytical result in the case of FIG. 6, so that a resonance frequency is different from that in the case of FIG. 6. Therefore, absolute frequency comparison cannot be made between FIG. 6 and FIG. 7.

As shown in FIG. 7, in the case of the four layers, a first resonance point T1 occurs at about 60 MHz and a second resonance point T2 occurs at about 120 MHz. In the case of the two layers, the first resonance point P1 occurs at about 110 MHz and the second resonance point P2 occurs at about 200 MHz. In the case of the single layer, the first resonance point R1 occurs at about 190 MHz.

In the case of FIG. 7, an impedance in a conductive domain up to each of the first resonance points (T1, P1, and R1) reduces as the number of layers increases as in the case of FIG. 6. This indicates an increase in capacitance of a capacitor by parallel connection of the BC layers 6.

A band width up to the resonance point (for example, a band up to each of the first resonance points T1, P1, and R1) becomes narrower as the number of layers increases. This is possibly because a new resonance mode is caused by the parallel connection of the BC layers 6.

As described above, according to the structure in this embodiment, the plurality of power supply layers 3 are connected with each other through the power supply via 7B and the plurality of ground layers 5 are connected with each other through the ground via 8. Therefore, it is possible to increase a capacitance of each of the BC layers 6 serving as capacitors.

In this case, the band up to each of the resonance points becomes narrower as the number of layers increases. However, as shown in FIG. 5, when the number of power supply vias 7B and the number of ground vias 8 increase, each of the resonance points can be shifted to the high frequency side. That is, according to the multilayer printed board in this embodiment, when the plurality of BC layers 6 are connected with each other, it is possible to reduce the low frequency side impedance. Further, when the number of vias increases, the resonance point can be shifted to the high frequency domain to widen a band width.

### <Embodiment 2>

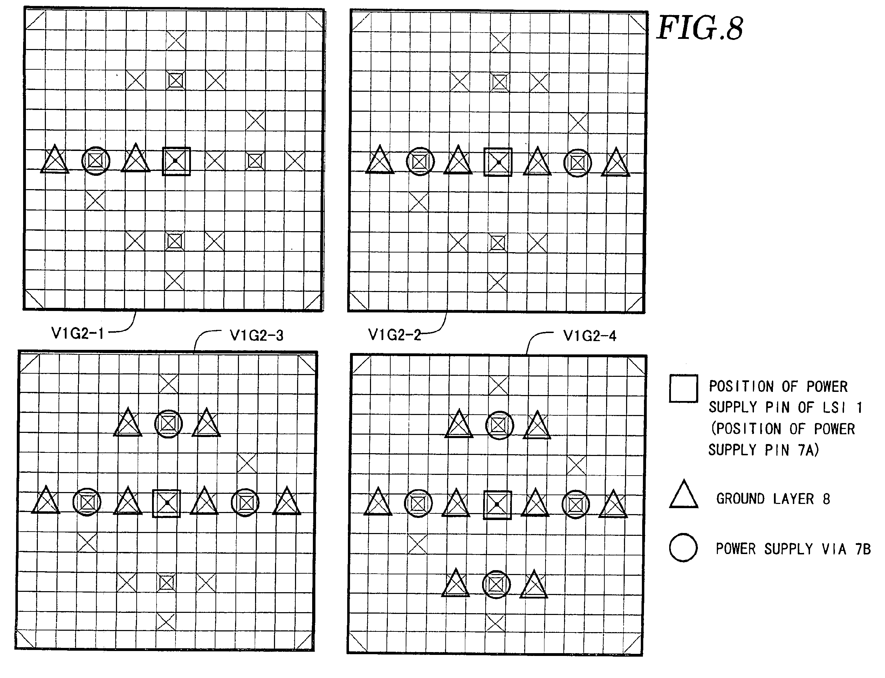

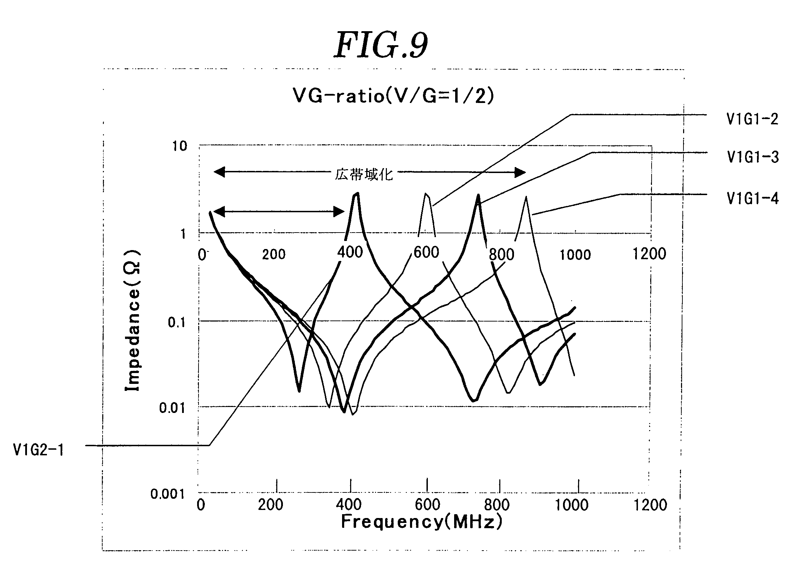

FIG. 8 and FIG. 9 show Embodiment 2. In Embodiment 1, the number of power supply vias 7B is made equal to the number of ground vias 8. They are increased from one set (V1G1-1) to five sets (V1G1-5) by one and the impedance characteristic of the BC layers 6 are calculated. In Embodiment 2, a ratio between the number of power supply vias 7B and the number of ground vias 8 is set to 1:2. Such a combination is increased from one set to four sets and the impedance characteristic of the BC layers 6 are calculated. Other structures are identical to those in Embodiment 1.

FIG. 8 shows the position of the power supply pin of the LSI 1 (power supply via 7A) and the positions of the power supply vias 7B and the ground vias 8 in this embodiment. As shown in FIG. 8, even in any of V1G2-1 to V1G2-4, a pair of ground vias 8 are provided on both sides of each of the power supply vias 7 to make one set.

In the case of V1G2-1, the one set is provided on the left side of the power supply pin of the LSI 1. In the case of V1G2-2, the one set is further provided on the right side of the power supply pin of the LSI 1 as compared with the case of V1G2-1. In the case of V1G2-3, the one set is further provided on the upper side of the power supply pin of the LSI 1 as compared with the case of V1G2-2. In the case of V1G2-4, the one set is further provided on the lower side of the power supply pin of the LSI 1 as compared with the case of V1G2-3.

FIG. 9 shows a frequency characteristic of an impedance of the BC layers 6. Even in FIG. 9, the characteristic of the impedance of the BC layers 6 is similar to that shown in FIG. 5. That is, as is apparent from the cases V1G2-1 to V1G2-4, when the number of sets of the power supply via 7B and the ground via 9 increases, the resonance point is shifted to the high frequency domain to widen the band width.

### <Embodiment 3>

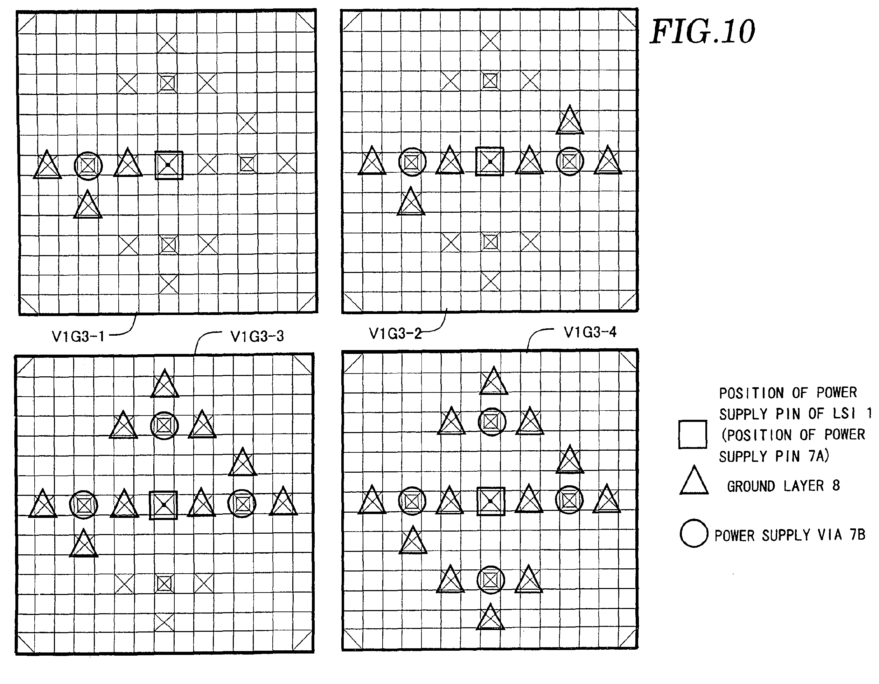

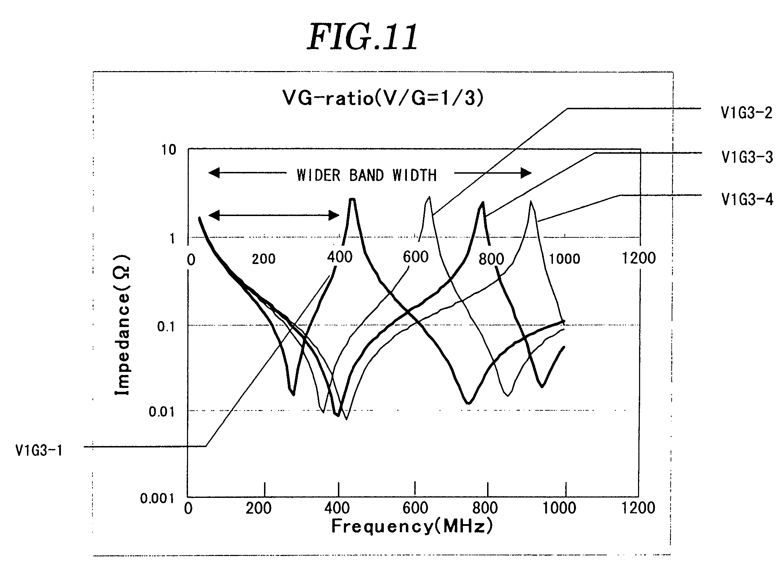

FIG. 10 and FIG. 11 show Embodiment 3. In Embodiment 1, the number of power supply vias 7B is made equal to the number of ground vias 8. They are increased from one set (V1G1-1) to five sets (V1G1-5) by one and the impedance characteristic of the BC layers 6 are calculated. In Embodiment 2 , the ratio between the number of power supply vias 7B and the number of ground vias 8 is set to 1:2 and the same analysis is performed.

In Embodiment 3, the ratio between the number of power supply vias 7B and the number of ground vias 8 is set to 1:3. Such a combination is increased from one set to four sets and the impedance characteristic of the BC layers 6 are calculated. Other structures are identical to those in Embodiment 1 or 2.

FIG. 10 shows the position of the power supply pin of the LSI 1 (power supply via 7A) and the positions of the power supply vias 7B and the ground vias 8 in this embodiment. As shown in FIG. 10, even in any of V1G3-1 to V1G3-4, the ground vias 8 are provided on three sides of each of the power supply vias 7B to make one set. In this case, a set in which the ground vias 8 are provided on the left, right, and lower sides of the power supply via 7B is referred to as a type 1. A set in which the ground vias 8 are provided on the left, right, and upper sides of the power supply via 7B is referred to as a type 2.

In the case of V1G3-1, the set of the type 1 is provided on the left side of the power supply pin of the LSI 1. In the case of V1G3-2, the set of the type 2 is further provided on the right side of the power supply pin of the LSI 1 as compared with the case of V1G3-1. In the case of V1G3-3, the set of the type 2 is further provided on the upper side of the power supply pin of the LSI 1 as compared with the case of V1G3-2. In the case of V1G3-4, the set of the type 1 is further provided on the lower side of the power supply pin of the LSI 1 as compared with the case of V1G3-3.

FIG. 11 shows a frequency characteristic of an impedance of the BC layers 6. Even in FIG. 11, the characteristic of the impedance of the BC layers 6 is similar to that shown in FIG. 5 or FIG. 9. That is, as is apparent from the cases of V1G3-1 to V1G3-4, when the number of sets of the power supply via 7B and the ground via 9 increases, the band width widens.

### <Modified Example>

In the first embodiment mode, as shown in FIG. 1 or FIG. 2, each of the BC layers is composed of the power supply layer 3, the thin film dielectric 4, and the ground layer 5. The multilayer printed board is constructed based on this order (for example, the order in which the power supply layer 3, the thin film dielectric 4, and the ground layer 5 are provided as viewed from the printed board (multiple layers) 2-1 in FIG. 2).

However, the embodiment of the present invention is not limited to such a structure. For example, a positional relationship between the power supply layer 3 and the ground layer 5 may be arbitrarily changed in the BC layer 6.

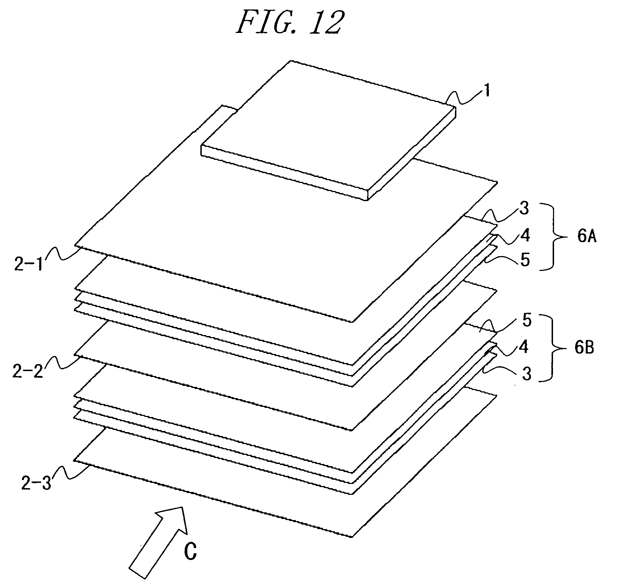

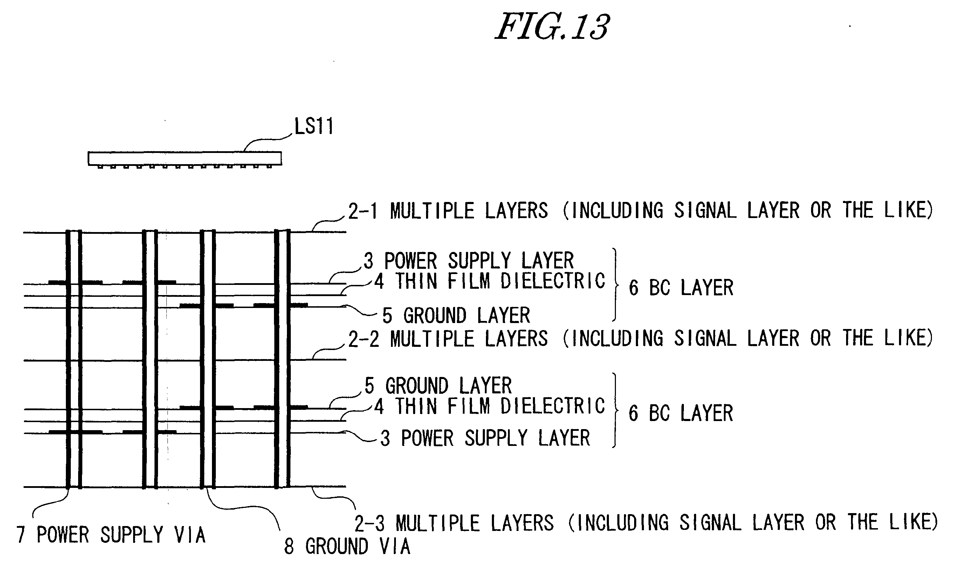

FIG. 12 and FIG. 13 show an example of such a multilayer printed board. FIG. 12 is a perspective view showing a modified example of the multilayer printed board according to the first embodiment mode. FIG. 13 is a front view showing the multilayer printed board viewed from a direction indicated by an arrow C in FIG. 12.

In this example, the multilayer printed board includes two BC boards 6A and 6B. The BC board 6A has the power supply layer 3, the thin film dielectric 4, and the ground layer 5 which are provided in this order as viewed from the printed board (multiple layers) 2-1. The BC board 6B has the ground layer 5, the thin film dielectric 4, and the power supply layer 3 which are provided in this order as viewed from the printed board (multiple layers) 2-1. With respect to the plurality of BC layers 6A and 6B, the power supply layers 3 are connected with each other through the power supply via 7B and the ground layers 8 are connected with each other through the ground via 8. Even when the BC layers 6A and 6B are constructed as described above, an analytical result is identical to the results shown in FIGS. 5 to 7, 9, and 11.

Even when the multilayer printed board includes over two BC layers 6, the order in which the power supply layer 3 and the ground layer 5 are provided in the BC layer 6 is not limited. That is, even in an arbitrary combination of the BC layers 6A and 6B as shown in FIG. 12, the impedance characteristic is not significantly different from that in the case where a plurality of any one of the BC layer 6A and 6B are combined as in the first embodiment mode.

In the first embodiment mode, the BC layers 6 and other layers such as the printed boards 2-1 and 2-2 are formed in substantially the same shape. However, the embodiment of the present invention is not limited to the same shape.

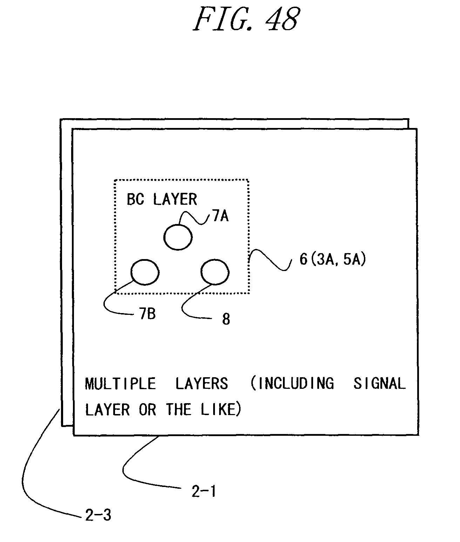

FIG. 48 shows a modified example of the multilayer printed board according to this embodiment mode in the case where it is viewed from the upper side (for example, in the direction indicated by the arrow B in FIG. 3). As shown in FIG. 48, a size of the BC layer 6 may be smaller than sizes of the other printed boards. That is, a metallic coating portion 3A of the power supply layer 3 may be formed in a portion of a board composing the power supply layer 3 and a metallic coating portion 5A of the ground layer 5 may be formed in a portion of a board composing the ground layer 5. This applies to the case where the BC layer is provided only in the vicinity of the specific LSI 1. Therefore, even when a portion of the multilayer printed board composes the BC layer 6, the present invention can be implemented.

That is, the plurality of power supply layers 3 included in the multilayer printed board may be connected with each other through the power supply via 7B. The plurality of ground layers 5 included in the multilayer printed board may be connected with each other through the ground via 8.

### <<Second Embodiment Mode>>

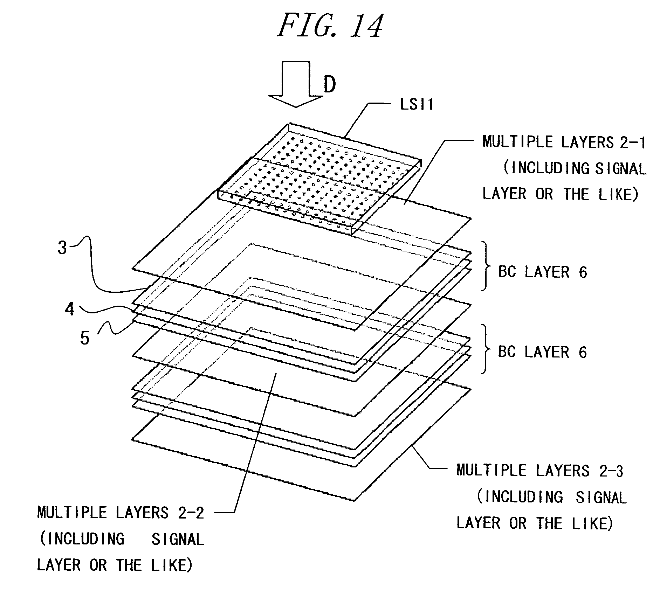

Hereinafter a multilayer printed board according to a second embodiment mode of the present invention will be described with reference to FIG. 14 to FIG. 35. The first embodiment mode shows the impedance characteristic of the multilayer printed board in which the power supply layers 3 included in the plurality of BC layers 6 are connected with each other through the power supply via 7 (7B) and the ground layers 5 included in the plurality of BC layers 6 are connected with each other through the ground via 8.

Meanwhile, this embodiment mode shows an example of a multilayer printed board in which a power supply pin for supplying power to an element is provided near the central axis of the BC layer 6 to improve an impedance characteristic. Other structures and operations are identical to those in the first embodiment mode. Therefore, the same symbols are provided to the same constituent elements and their descriptions are omitted here.

### <Structure>

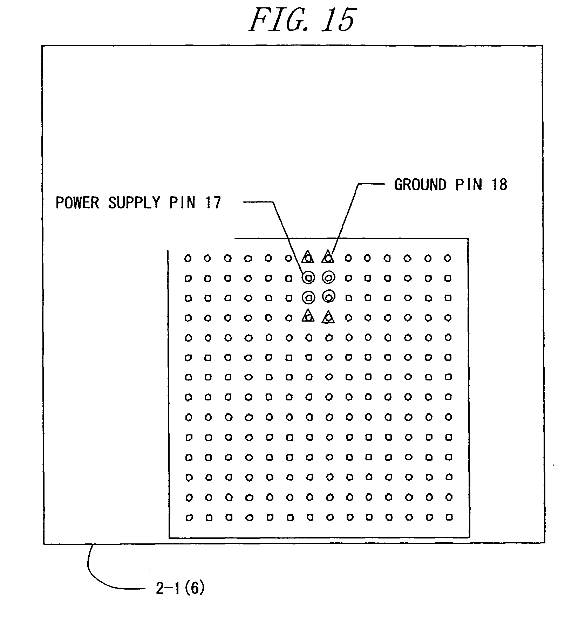

FIG. 14 and FIG. 15 show an outside of the multilayer printed board according to the second embodiment mode of the present invention. FIG. 14 is a perspective view showing the multilayer printed board. FIG. 15 is a plan view showing the multilayer printed board in the case where it is viewed from a direction indicated by an arrow D in FIG. 14.

As shown in FIG. 14, the multilayer printed board is a multilayer printed board which includes the printed boards (multiple layers including a signal layer) 2-1, 2-2, and 2-3 and the BC layers 6 and a position in which the LSI 1 is mounted is devised. Here, it is desirable that the LSI 1 be an element to or from which a signal driven at highest speed is inputted or outputted on the multilayer printed board.

As shown in FIG. 14, the number of signal layers is not particularly limited in the multilayer printed board. That is, the number of signal layers may be one or plural.

In FIG. 14, the multilayer printed board includes the two BC layers 6. However, in the embodiment of the present invention, the number of BC layers 6 may be one. As in the first embodiment, the two or more BC layers 6 may be provided, the power supply layers 3 of the respective BC layers may be connected with each other through the power supply via, and the ground layers 5 may be connected with each other through the ground via.

As shown in FIG. 15, the feature of the multilayer printed board according to this embodiment mode is to locate power supply pins 17 of the LSI 1 substantially at the center of the BC layer 6 of the multilayer printed board. According to such location, the power supply vias connected with the power supply pins 17 can be formed near the central axis passing through the substantially center of the BC layer 6. In the example shown in FIG. 15, ground pins 18 are located adj acent to the power supply pins 17.

Note that in the multilayer print shown in FIG. 14, the respective printed boards (multiple layers 2-1, 2-2, and 2-3 and the BC layers 6) have substantially the same size (rectangle of 50 mm square) in the plan view as viewed from the direction indicated by the arrow D in FIG. 14.

### <Natural Resonance Frequency of Board>

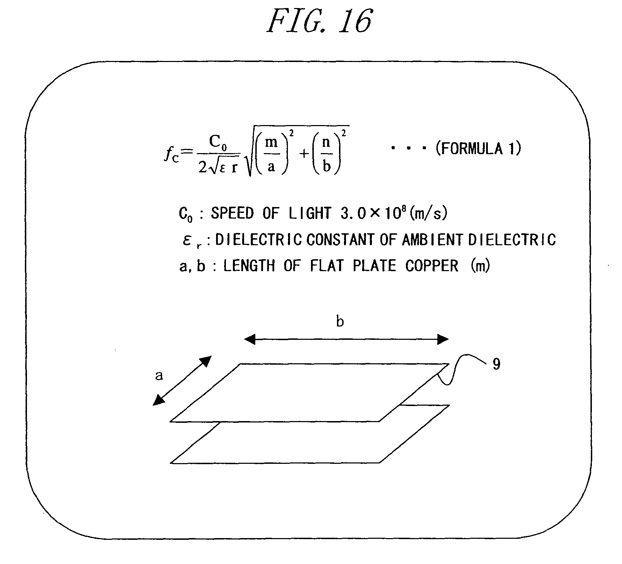

FIG. 16 is an explanatory view of a natural resonance frequency of a printed board. FIG. 16 shows a natural resonance frequency of a rectangular copper sheet to a high frequency signal. Here, the copper sheet is indicated by a rectangular sheet 9 of a size of a (meters) × b (meters). Assume that a dielectric having a dielectric constant er exists around the rectangular sheet 9 made of copper. At this time, it is experimentally known that the natural resonance frequency can be expressed by formula 1.

In the formula 1, C₀ denotes the speed of light in a vacuum. In the formula 1, m and n each denote an integer equal to or larger than 0 (at least one is equal to or larger than 1) and are determined according to a resonance mode.

For example, when the dielectric constant er=3.12, a=0.05 (meters), and b=0.05 (meters), a first resonance frequency fc (in the case of m=1 and n=0) is calculated to be 1.69 GHz.

This embodiment mode shows that the power supply pins 17 of the LSI 1 and the power supply vias 7 can be located near the center of the BC layer 6 to suppress such resonance.

It is expected that the resonance occurs in the case where the 1/2-wavelength of a high frequency signal is substantially equal to, for example, the length "a" (in the case of m=1). In addition, it is expected that the resonance occurs in the case where the 1/2-wavelength of the high frequency signal is substantially equal to, for example, the length "b" (in the case of n=1). Note that there is a resonance mode which cannot be determined by the experimental formula 1 shown in FIG. 16 in an actual printed board.

In the multilayer printed board, the power supply pins 17 of the LSI 1 and the power supply vias 7 are located at the central position of the BC layer 6 (on the central axis of a thin copper plate for forming the power supply layer 3 and the ground layer 5 (on an axial direction perpendicular to the thin copper plate)). According to such location, a distance between a signal generation position of the BC layer 6 (position of the power supply via connected with the power supply pin 17 on the BC layer 6) and an end portion of the BC layer 6 (side of the rectangular thin copper plate for forming the power supply layer 3) becomes shorter. Therefore, the distance between the signal generation position and the end portion of the BC layer 6 does not become equal to the 1/2-wavelength of the high frequency signal. Thus, the natural resonance in the BC layer 6 is suppressed.

In an actual design, the power supply pins 17 of the LSI 1 and the power supply vias connected therewith cannot be located near the accurate central axis of the BC layer 6 in some case. In such a case, the degree of suppression to the natural resonance is changed according to a deviation from the accurate central position. As described in the following embodiment, a radiation electric field intensity caused by the resonance increases as the power supply via is located near to one of the end portions of the BC layer 6. Note that an effect in which a radiation electric field strength is reduced by about 10 dB as compared with a worst value is obtained in a range of 20% of a distance off from the center, between the center of the BC layer 6 and the end portion of the rectangular thin copper plate.

### <Embodiment 4: Result Obtained by Impedance Measurement>

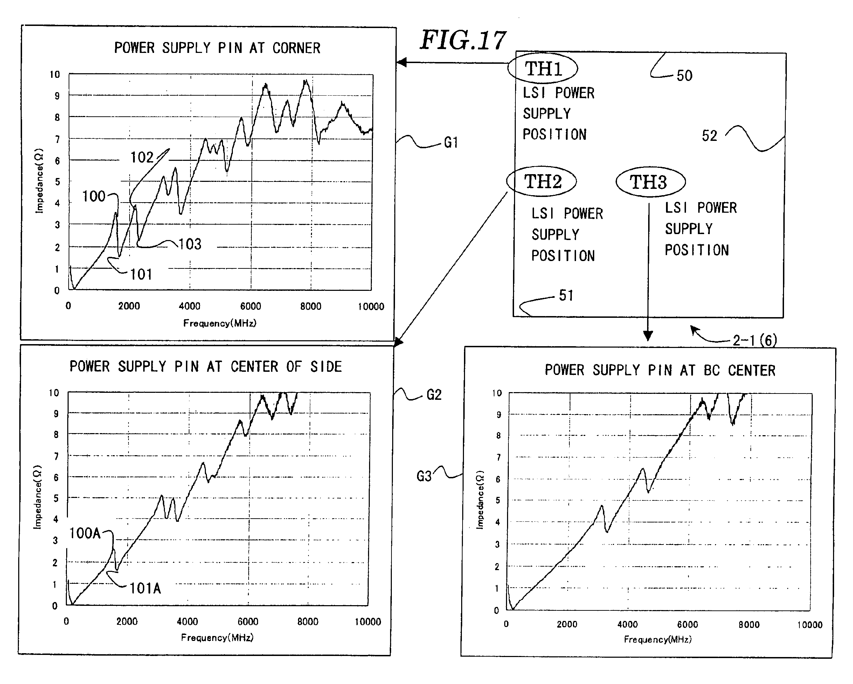

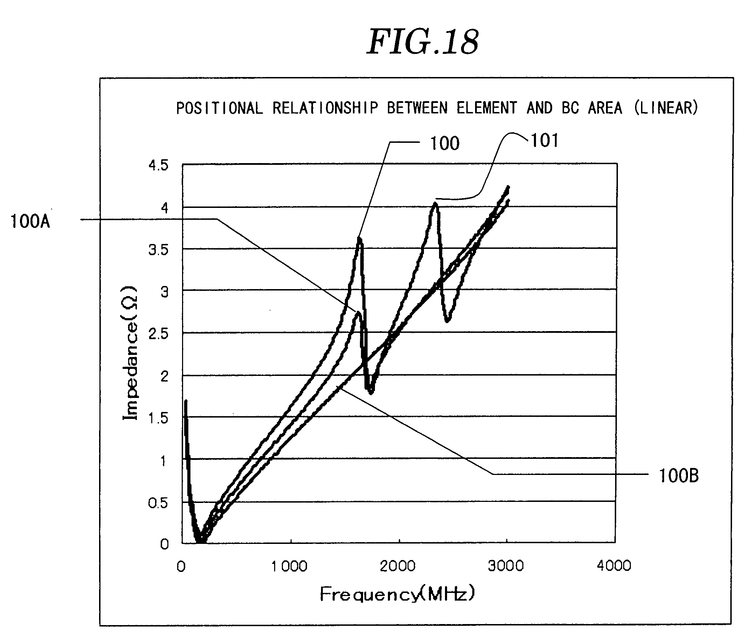

FIG. 17 and FIG. 18 show Embodiment 4 of the present invention. A multilayer printed board is a square in which a flat size of each layer is 50 mm × 50 mm. The multilayer printed board includes a single BC layer. The BC layer is composed of a power supply layer, a thin film dielectric, and a ground layer. A thickness of the thin film dielectric is 25 microns as in the first embodiment mode. Each of layers located above and below the BC layer has an insulator having a thickness of 40 microns.

FIG. 17 shows a shape of the printed board 2-1 (or the BC layer 6) in the case where the multilayer printed board is viewed from the direction indicated by the arrow D in FIG. 14. TH3 indicates a through hole passing through the vicinity of the central position of the BC layer 6. An axis which corresponds to the through hole and is perpendicular to a paper surface is referred to as the central axis of the BC layer 6.

Similarly, TH1 indicates a through hole passing through the vicinity of a vertex of the rectangular BC layer 6. Similarly, TH2 indicates a through hole passing through the vicinity of the center of a square side composing the BC layer 6. As described in the first embodiment mode, a power supply via is formed in each of the through holes. Each power supply via is connected with the power supply layer 3. An outer diameter of the power supply via in this embodiment is 0.3 mm equal to that in the first embodiment mode.

As shown in FIG. 17, in this embodiment mode, the power supply pins of the LSI 1 are located at the positions of TH1 to TH3 and connected with the vias located at the respective positions to produce three kinds of multilayer printed boards. In each of the multilayer printed boards, the impedance between the power supply layer 6 and the ground layer 7 is measured.

In the measurement, a black box is assumed between the power supply layer 3 and the ground layer 5 which compose the BC layer 6. A S (scattering) parameter is obtained using a network analyzer. The impedance between the power supply layer 3 and the ground layer 5 is obtained from the value of the S parameter. Note that a matrix representation of the S parameter is called a S matrix. A procedure for obtaining the impedance of the black box from the S matrix is known.

As shown in the abscissa of each of graphs G1 to G3, a frequency is changed from the vicinity of 0 Hz to the vicinity of 10 GHz to measure the impedance. In the graphs G1 to G3, peaks and valleys (for example 100 and 101 in G1) each indicate a resonance point.

As is apparent from G3 shown in FIG. 17, when the power supply pin 17 of the LSI 1 is located in TH3, peaks 100 to 103 present in G1 disappear. This may be because a distance between the position of the TH3 and an outer edge of the BC layer 6 (thin copper plate of the power supply layer 3) is shorter than the 1/2-wavelength of the high frequency wave. That is, although the high frequency wave is injected from the via formed at the position of the TH3 to the BC layer 6, the resonance caused thereby is suppressed.

As is apparent from a result obtained by measurement in G2, the peaks 102 and 103 present in G1 disappear. This may be because a distance between the position of the TH2 and each of sides (sides 50 and 51) of the BC layer 6 (thin copper plate of the power supply layer 3) is shorter than the 1/2-wavelength of the high frequency wave at the resonance frequency. On the other hand, the peaks 100 and 101 present in G1 do not disappear even in the result obtained by measurement in G2 (they are present as peaks 100A and 101A). This may be because a distance between the position of the TH2 and an opposite side (side 52) of the BC layer 6 (thin copper plate of the power supply layer 3) is close to the 1/2-wavelength of the high frequency wave at the resonance frequency.

FIG. 18 shows the superposition of results of G1 to G3 obtained by measurement as shown in FIG. 17. As shown inFIG. 18, a resonance characteristic of the peak 100A in the result G2 becomes weaker than that of the peak 100 in the result G1. Note that each of frequencies of the peaks is substantially equal to a result obtained by calculation based on the formula 1 and is about 1690 MHz. In the result of G3, as indicated by reference 100B, the peak in the vicinity of 1.69 GHz disappears.

### <Analytical Result of Current Distribution>

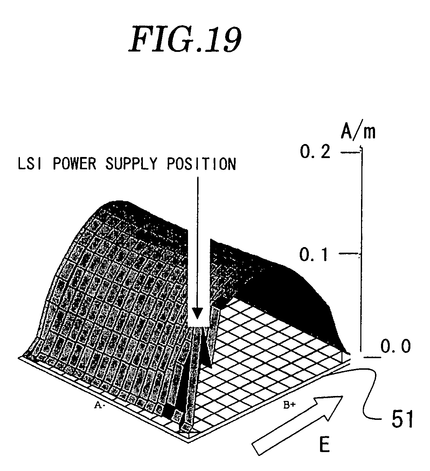

FIGS. 19 to 24 show analytical results of a high frequency current distribution in the vicinity of the resonance frequency in each of the cases where the power supply pin 17 of the LSI 1 is located in TH1 to TH3. In this analysis, it is assumed to leak a high frequency signal from the power supply pin 17 and a current distribution in each of the cases where a high frequency voltage is supplied from the positions of TH1 to TH3 is obtained.

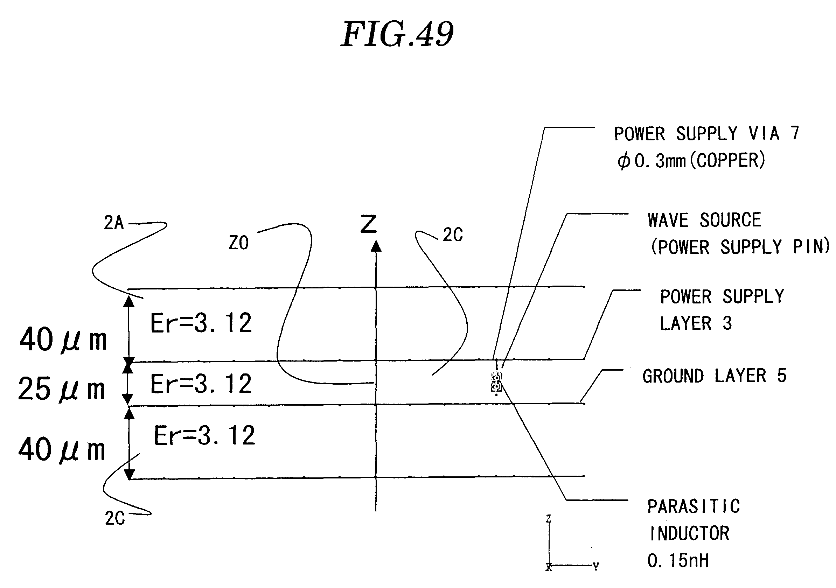

FIG. 49 shows an analytical model of the multilayer printed board according to this embodiment mode. As shown in FIG. 49, the analytical model includes a thin film dielectric 2A, the power supply layer 3, a thin film dielectric 2B, the ground layer 5, and a thin film dielectric 2C. The thin film dielectrics 2A, 2B, and 2C have 40 microns, 25 microns, and 40 microns in thickness, respectively. Each of the thin film dielectrics 2A, 2B, and 2C has a dielectric constant Er of 3.12.

In this model, a wave source (high frequency power supply) is set between the power supply layer 3 and the ground layer 5. The wave source is connected with the power supply layer 3 and the ground layer 5 through the via. The wave source is originally necessarily set to the power supply via that connects the power supply pin of the LIS mounted on the multilayer printed board with the power supply layer. However, as in the first embodiment mode, the wave source is set to the above-mentioned position for simplification of the model. In order to fit the simplified model to a measured value, a parasitic inductor is set to the power supply via.

As in the first embodiment mode, a high frequency power supply signal has a trapezoid waveform whose rise time and fall time each are 500 ps, period is 100 MHz, and amplitude is 3.3 volts.

Even in the analysis, the electromagnetic analysis program based on the piecewise sinusoidal moment method is used as in the first embodiment mode. Hereinafter, FIG. 19 to FIG. 21 show current distributions at a frequency of 1600 MHz, each of which corresponds to the vicinity of the peak 100 shown in FIG. 18.

FIG. 19 shows an analytical result of a current distribution in a direction indicated by an arrow E in the case where the power supply pin 17 is located in TH1 shown in FIG. 17. In the analysis, the wave source is set just below TH1 and between the power supply layer 3 and the ground layer 5 (see FIG. 49). As shown in FIG. 19, a current in the direction indicated by the arrow E produces a distribution having a mountain shape with respect to the side 51 of the BC layer 6. A peak of the mountain shape corresponds to a current density of about 0.1 A/m.

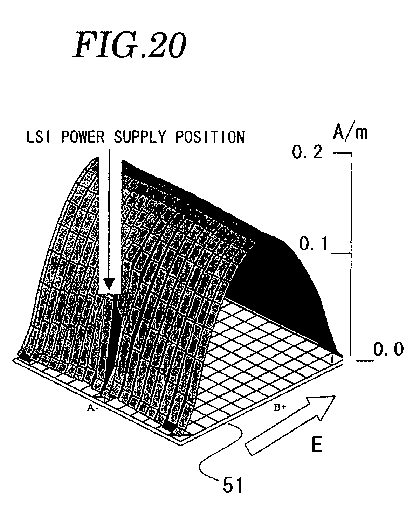

FIG. 20 shows an analytical result of a current distribution in the direction indicated by the arrow E in the case where the power supply pin 17 (power supply via 7) is located in TH2 shown in FIG. 17. In the analysis, the wave source is set just below TH2 and between the power supply layer 3 and the ground layer 5 (see FIG. 49). As shown in FIG. 20, even in this case, a current in the direction indicated by the arrow E produces a distribution having a mountain shape with respect to the side 51 of the BC layer 6. A peak of the mountain shape corresponds to a current density of about 0.15 A/m.

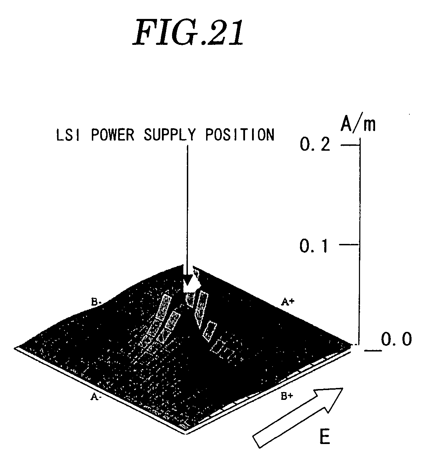

FIG. 21 shows an analytical result of a current distribution in the direction indicated by the arrow E in the case where the power supply pin 17 (power supply via 7) is located in TH3 shown in FIG. 17. In the analysis, the wave source is set just below TH3 and between the power supply layer 3 and the ground layer 5 (see FIG. 49). As shown in FIG. 21, in this case, a current in the direction indicated by the arrow E is locally produced in the vicinity of the position of the power supply pin 17 of the LSI 1. A peak of the current at a narrowly limited area close to the position of the power supply pin 17 corresponds to about 0.75 A/m.

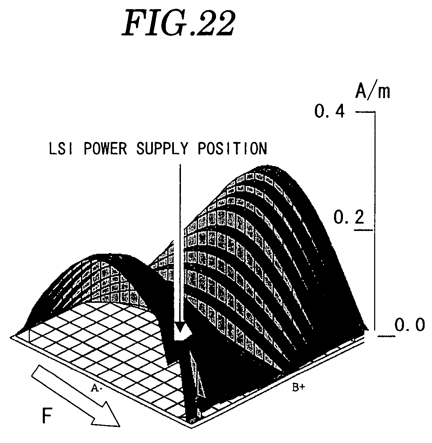

Hereinafter, FIG. 22 to FIG. 24 show current distributions at a frequency of 2330 MHz , each of which corresponds to the vicinity of the peak 101 shown in FIG. 18. FIG. 22 shows an analytical result of a current distribution in a direction indicated by an arrow F in the case where the power supply pin 17 is located in TH1 shown in FIG. 17. As shown in FIG. 22, a current in the direction indicated by the arrow F produces a mountain-shaped distribution having a saddle portion. The reason why the saddle portion is formed may be that the resonance mode is different from that in the case of FIG. 19. In FIG. 22, a peak of the mountain shape corresponds to a current density of about 0.3 A/m.

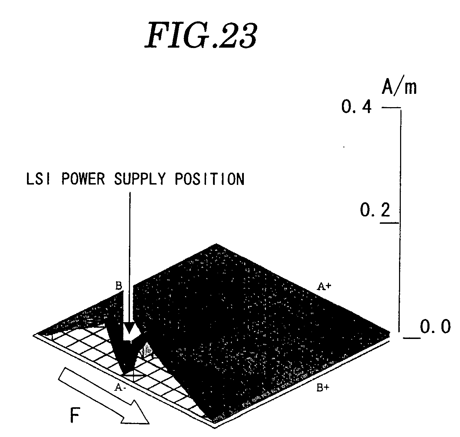

FIG. 23 shows an analytical result of a current distribution in the direction indicated by the arrow F in the case where the power supply pin 17 is located in TH2 shown in FIG. 17. As shown in FIG. 23, in this case, a current in the direction indicated by the arrow F is locally produced in the vicinity of the position of the power supply pin 17 of the LSI 1. A peak of the current at a narrowly limited area close to the position of the power supply pin 17 corresponds to about 0.75 A/m. This is because a distance between a voltage supply point and the side 50 or 51 in the direction indicated by the arrow F is not equal to an integral multiple of a half wavelength of the high frequency wave at the resonance frequency (2.333 GHz).

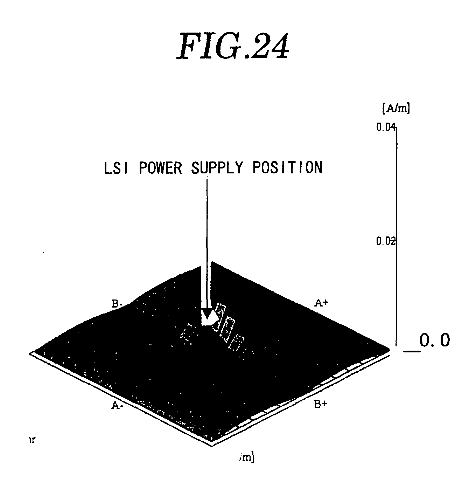

FIG. 24 shows an analytical result of a current distribution in the direction indicated by the arrow F in the case where the power supply pin 17 is located in TH3 shown in FIG. 17. The analytical result shown in FIG. 24 is substantially identical to that in the case of FIG. 21.

### <Analytical Result of Radiation Electric Field Strength>

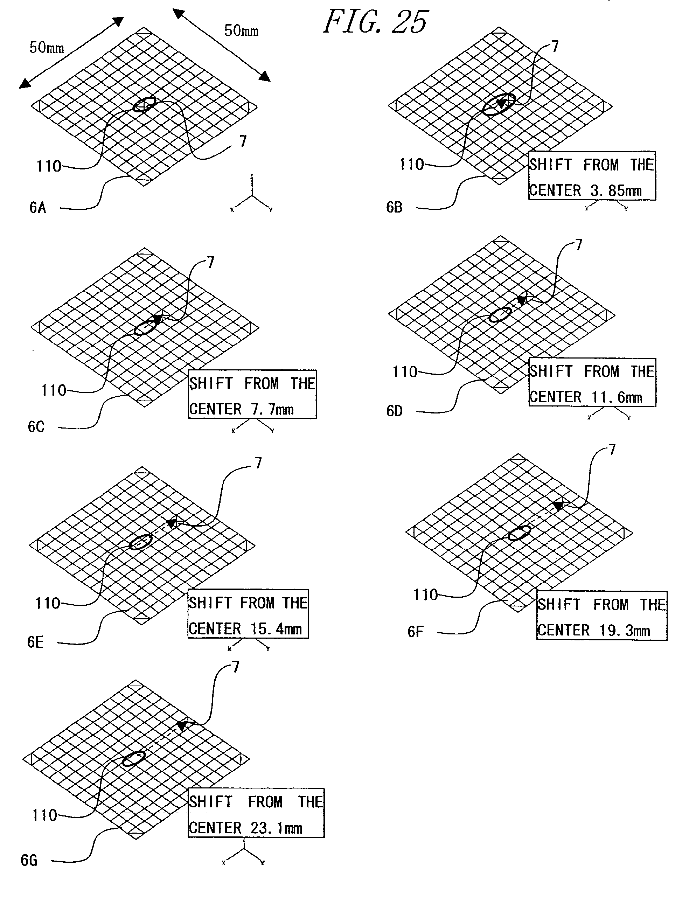

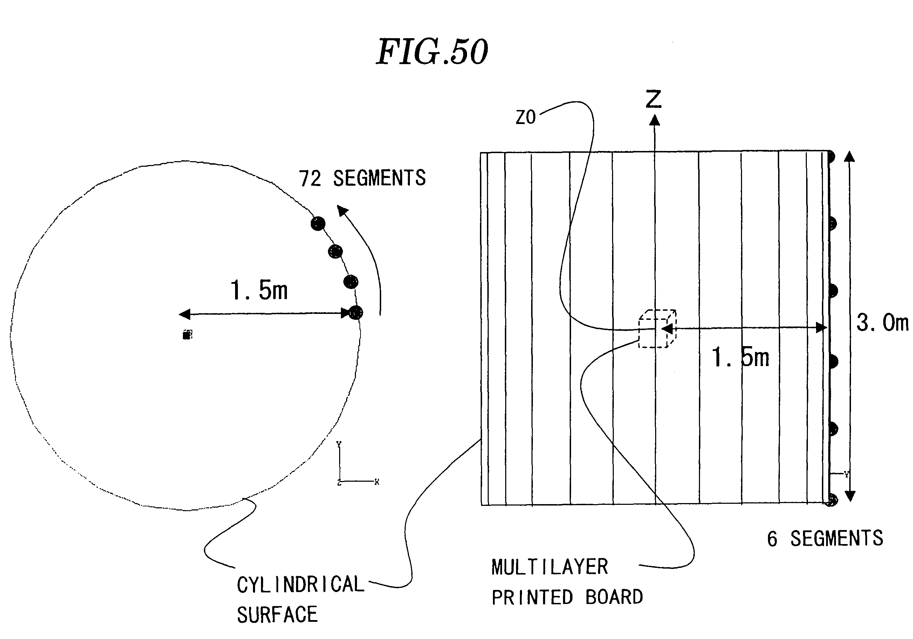

FIG. 25 to FIG. 35 show analytical results of a radiation electric field strength caused by an electromagnetic wave from the multilayer printed board. In the analysis, the electromagnetic wave emitted from the model of the multilayer printed board as shown in FIG. 49 is analyzed at each of positions shown in FIG. 50 to obtain a maximal value of the electric field strength. The reason why the maximal value of the electric field strength is obtained is to obtain an electric field strength at a position in which a directivity of a radiation pattern formed by the multilayer printed board becomes maximal.

According to the analysis, when current distributions of the model of the multilayer printed board as shown in FIG. 49 are obtained, electric field strengths can be obtained by solving Maxwell equations with respect to the respective current distributions. This becomes, for example, the superposition of radiation electric fields caused by respective currents obtained on a mesh as shown in FIG. 25.

FIG. 50 shows observation points of the radiation electric field strength. As shown in FIG. 50, a cylindrical coordinates system is used and the multilayer printed board is located at the center of the cylinder. At this time, the central axis (z-axis) of the cylinder is aligned with a normal line passing through the center of the multilayer printed board. Divisional lines parallel to the z-axis are set by which a cylindrical surface distanced from the central axis by a radius of 1.5 m is divided into 72 segments in a circumferential direction.

Divisional lines in the circumferential direction are set by which the cylindrical surface is divided into 6 segments within an area of 3 m in a Z-direction. Positions of the divisional lines in the circumferential direction correspond to Z = 1.5 m, 0.9 m, 0. 3 m, -0.3 m. -0. 9 m, and -1.5 m. In this case, the central position of the multilayer printed board in the Z-direction (position of Z0 shown in FIG. 49) is set to Z=0 in the cylindrical coordinates. Intersections of the divisional lines parallel to the z-axis and the divisional lines in the circumferential direction are set to the observation points. When the electric filed strength is measured, an antenna for measuring vertical polarization and horizontal polarization may be set in the observation points.

FIG. 25 shows a relationship between the central position of the BC layer 6 and the position of the power supply via 7 connected with the power supply pin 17 of the LSI 1 (position in which the wave source is projected when being projected to the BC layer 6). In FIG. 25, the BC layer 6 is specified using references 6A to 6G based on the position of the power supply via 7.

The drawing of the BC layer 6A shows the case where the power supply via 7 is located at a center 110 of the BC layer. In any cases (6A to 6G), assume that a flat surface of the BC layer is a square whose side length is 50 mm.

The drawing of the BC layer 6B shows the case where the power supply via 7 is shifted from the center 110 of the BC layer by 3.85 mm. In this case, according to expression using a relative amount in which positions of the four sides of the rectangle are set as 100%, the degree of shift of the power supply via 7 from the center 110 is 3.85/25 = 15.4%. In FIG. 25, a shift direction is a direction from the center of the BC layer to the center of a side of a rectangular region.

The drawing of the BC layer 6C shows the case where the power supply via 7 is shifted from the center 110 of the BC layer by 7.7 mm. In this case, according to the expression using the relative amount in which the positions of the four sides of the rectangle are set as 100%, the degree of shift of the power supply via 7 from the center 110 is 7.7/25 = 30.8%.

The drawing of the BC layer 6D shows the case where the power supply via 7 is shifted from the center 110 of the BC layer by 11.6 mm. In this case, according to the expression using the relative amount in which the positions of the four sides of the rectangle are set as 100%, the degree of shift of the power supply via 7 from the center 110 is 11.6/25 = 46.4%.

The drawing of the BC layer 6E shows the case where the power supply via 7 is shifted from the center 110 of the BC layer by 15.4 mm. In this case, according to the expression using the relative amount in which the positions of the four sides of the rectangle are set as 100%, the degree of shift of the power supply via 7 from the center 110 is 15.4/25 = 61.6%.

The drawing of the BC layer 6F shows the case where the power supply via 7 is shifted from the center 110 of the BC layer by 19.3 mm. In this case, according to the expression using the relative amount in which the positions of the four sides of the rectangle are set as 100%, the degree of shift of the power supply via 7 from the center 110 is 19.3/25 = 77.2%.

The drawing of the BC layer 6G shows the case where the power supply via 7 is shifted from the center 110 of the BC layer by 23.1 mm. In this case, according to the expression using the relative amount in which the positions of the four sides of the rectangle are set as 100%, the degree of shift of the power supply via 7 from the center 110 is 23.1/25 = 92.4%.

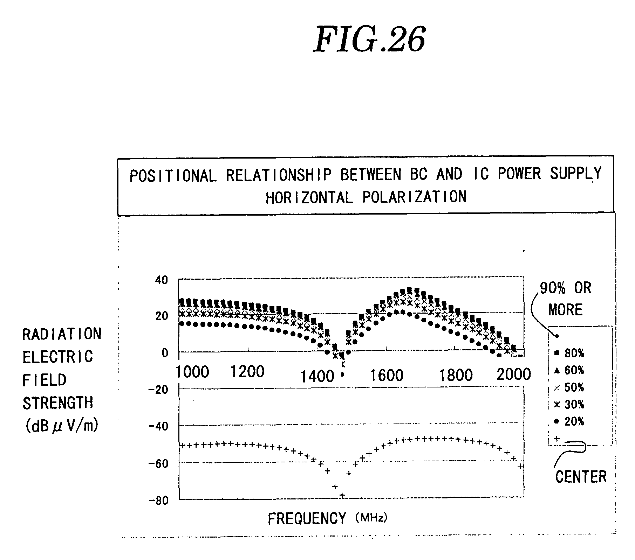

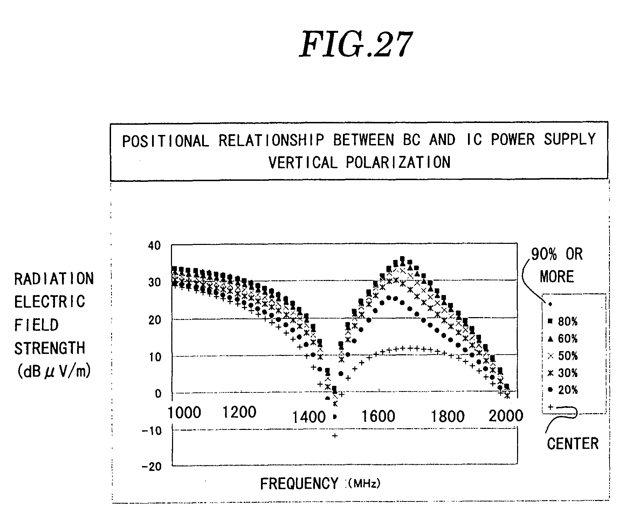

FIG. 26 and FIG. 27 show analytical results of the radiation electric field strength in the cases where the position of the power supply via 7 is changed (wave source shown in FIG. 49).

FIG. 26 is a plot showing a radiation electric field strength (horizontal polarization component) according to a positional relationship between the central position 110 and the power supply via 7 in the BC layer 6 based on a frequency. In FIG. 26, the positional relationship between the central position 110 and the power supply via 7 of the LSI 1 is expressed at a ratio thereof to a size of the entire BC layer. Here, when the power supply via 7 is on a side of the rectangle formed by the BC layer 6 (conductor composing the power supply layer and the ground layer), the ratio is 100%.

The ordinate in FIG. 26 indicates the radiation electric field strength of horizontal polarization in the case where a high frequency signal in each positional relationship is supplied to the power supply via 7 (wave source shown in FIG. 49) and its unit is dBµV/m. As described above, a signal from a high frequency power source set as the wave source has a trapezoid waveform whose rise time and fall time each are 500 ps, period is 100 MHz, and amplitude is 3.3 volts.

As shown in FIG. 26, in any positional relationship, the radiation electric field strength becomes maximal at a frequency of the vicinity of the 1690 MHz. Therefore, this is identical to the results (FIG. 17 and FIG. 18) or the analytical results (FIG. 19 to FIG. 24) as described earlier.

The horizontal polarization is very weak in the case where the power supply via 7 (power supply pin 17 of the LSI 1) is located at the center 110 of the BC layer.

On the other hand, the radiation electric field strength increases as the power supply via 7 (power supply pin 17 of the LSI 1) is shifted to a peripheral portion. Note that the electric field strength in the case of separation of 20% or less is reduced by substantially 10dB or more as compared with the case of separation of 90% or more between the central position 110 and the peripheral portion.

FIG. 27 shows an analytical result of a vertical polarization component under the same condition as that in the case of FIG. 26. As is apparent from FIG. 27, even in the vertical polarization, the radiation electric field strength becomes maximal at a frequency of the vicinity of the 1690 MHz.

Even when the power supply via 7 (power supply pin 17 of the LSI 1) is located at the center 110 of the BC layer, the vertical polarization becomes larger than the horizontal polarization.

Even in the case of the vertical polarization, the radiation electric field strength further increases as a projection position 17A of the power supply pin 17 of the LSI 1 is shifted to a peripheral portion. Note that the electric field strength in the case of separation of 20% or less is also reduced by substantially 10dB or more as compared with the case of separation of 90% or more between the central position 110 and the peripheral portion.

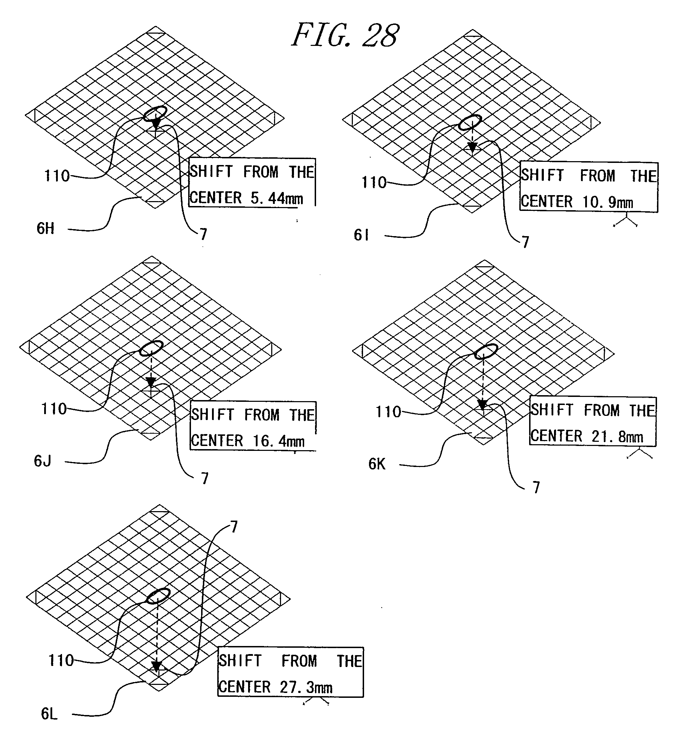

FIG. 28 shows respective states (6H to 6L) of the BC layer 6 in the cases where the power supply via 7 (power supply pin 17 of the LSI 1) is shifted from the central position in the vertex direction of the rectangle formed by the BC layer.

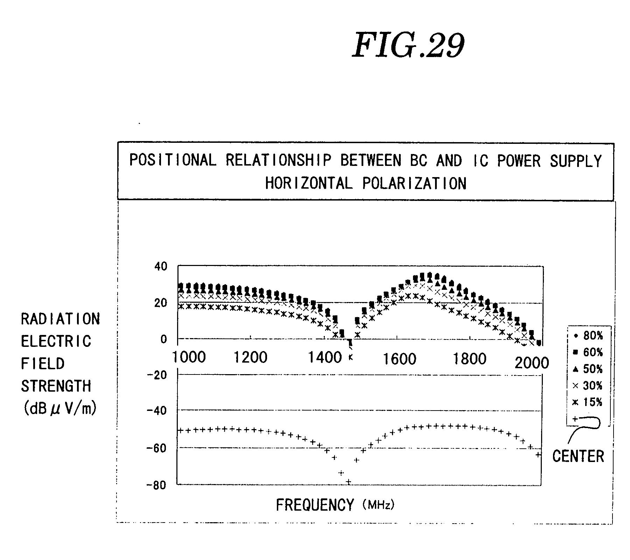

FIG. 29 shows a result obtained by analysis of the horizontal polarization of the radiation electric field strength in the case where the positional relationship is changed as shown in FIG. 28. Even in the case of the shift in the vertex direction as shown in FIG. 28, the same result as that shown in FIG. 26 is exhibited with respect to the horizontal polarization. Note that a position of 100% in FIG. 29 corresponds to a vertex position (each of four corner ends) of the rectangle formed by the BC layer as shown in FIG. 28.

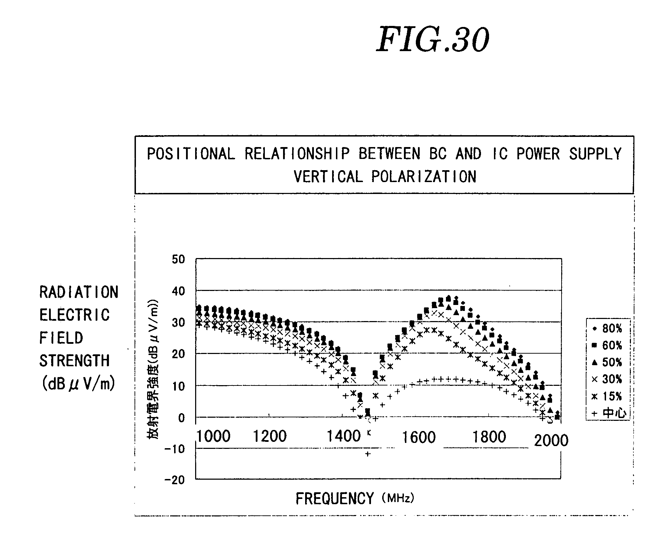

FIG. 30 shows a result obtained by analysis of the vertical polarization of a radiation electric field strength in the case where the positional relationship is changed as shown in FIG. 28. Even in the case of the shift in the vertex direction as shown in FIG. 28, the same result as that shown in FIG. 27 is exhibited with respect to the vertical polarization.

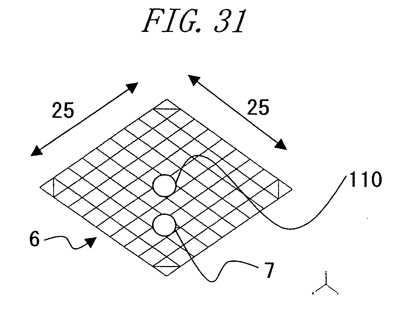

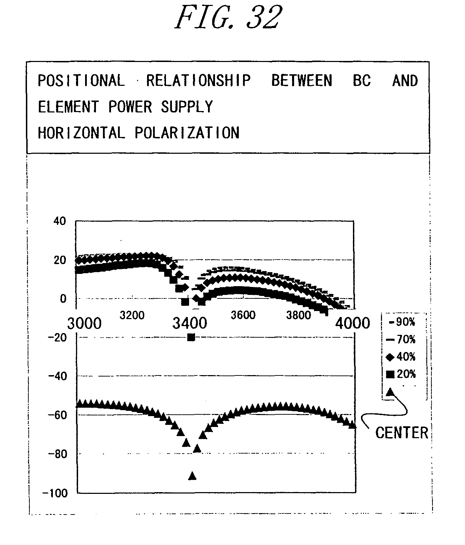

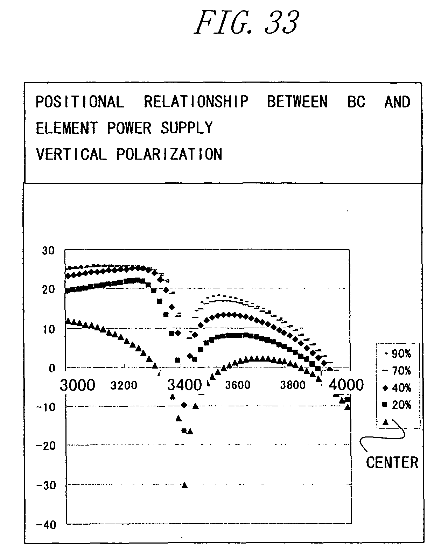

FIGS. 31 to 35 show results obtained by the same analysis as that shown in FIG. 25 to FIG. 30 with respect to the multilayer board including the BC layer 6 having a rectangular shape of 25 mm square. FIG. 31 shows a position of the power supply via 7 connected with the power supply pin 17 of the LSI 1 (wave source is set between the power supply layer and the ground layer). FIG. 32 shows an analytical result of horizontal polarization in the case where the power supply via 7 is shifted from the center 110 of the BC layer to the center of a side of the rectangle. FIG. 33 shows an analytical result of vertical polarization in such a case.

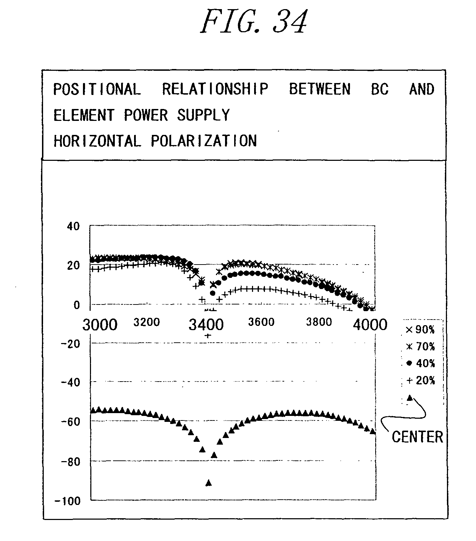

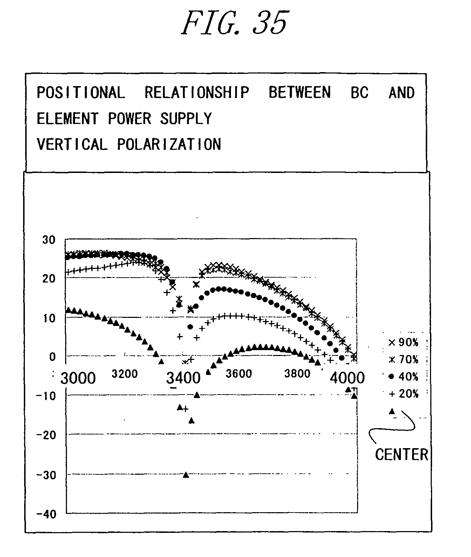

FIG. 34 shows an analytical result of horizontal polarization in the case where the power supply via 7 (and the wave source located just thereunder) is shifted from the center 110 of the BC layer in the vertex direction of the rectangle. FIG. 35 shows an analytical result of vertical polarization in such a case.

According to the formula 1 shown in FIG. 16, the natural resonance frequency of the square of 25 mm is twice that of a square of 50 mm and thus becomes 3.38 GHz. As shown in FIGS. 32 to 35, the electric field strength becomes maximal in the vicinity of the natural resonance frequency in any cases. In any cases, the radiation electric field strength increases as the power supply via 7 is shifted to the peripheral portion. Note that the electric field strength in the case of separation of 20% or less is also reduced by substantially 10dB or more as compared with the case of separation of 90% or more between the central position 110 and the peripheral portion.

As described above, when the power supply pin 17 of the LSI 1 (element having a highest operating frequency is desirable) on the signal layer in the multilayer printed board is located such that a projection position onto the BC layer 6 is close to the center of the BC layer 6, the natural resonance can be reduced. For example, when the power supply pin 17 of the LSI 1 on the signal layer is vertically connected to each board through the power supply via 7, it may be desirable that the power supply via 7 is provided close to the central portion of the BC layer.

Assume that a size of the entire board (end position of the rectangle formed from the BC layer) is 100%. At a position which is within an area of 20% from the central position 110, the electric field strength can be reduced by 10 dB or more as compared with the case where the power supply via 7 is located in the board end portion of the BC layer 6.

### <Modified Example>

In the first embodiment mode and the second embodiment mode, the BC layer 6 and another layer such as the signal layer 2-1 are formed in substantially the same shape. However, the embodiment of the present invention is not limited to such a shape.

For example, as shown in FIG. 48, the size of the BC layer 6 may be narrowed as compared with another printed board. FIG. 48 shows the modified example of the multilayer printed board according to this embodiment mode as viewed from the upper side (for example, in the direction indicated by the arrow D in FIG. 14).

That is, the metallic coating portion 3A of the power supply layer 3 may be formed in a portion of the board composing the power supply layer 3 and the metallic coating portion 5A of the ground layer 5 may be formed in a portion of the board composing the ground layer 5. This corresponds to the case where the BC layer 6 is provided only in the vicinity of the specific LSI 1 in the multilayer printed board. Therefore, even when a portion of the multilayer printed board composes the BC layer 6, the present invention can be embodied.

That is, the power supply via 7 of the LSI 1 may be located close to the center of the BC layer 6 with respect to the partial BC layer 6.

### <<Third Embodiment Mode>>

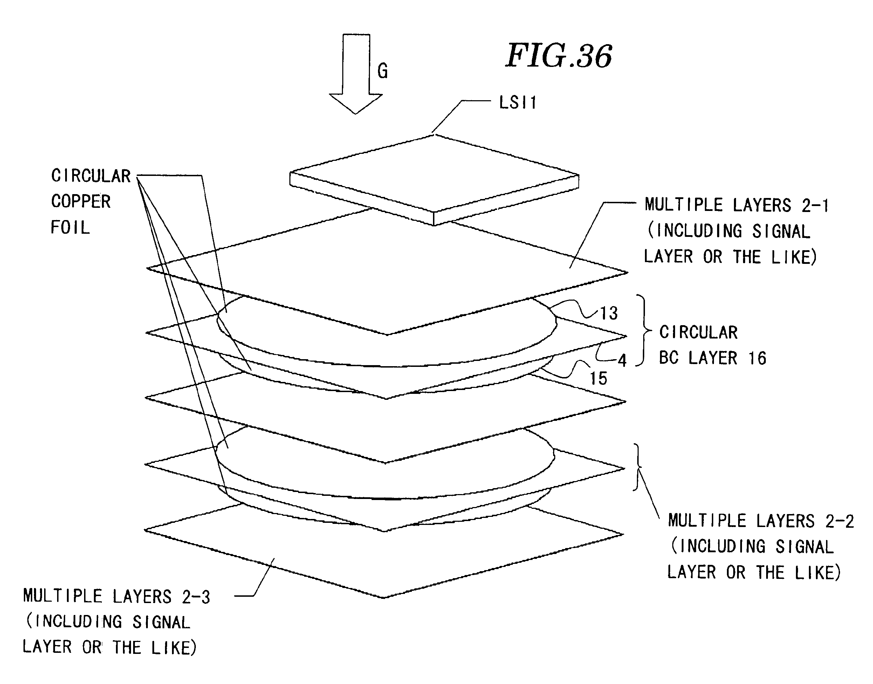

Hereinafter a multilayer printed board according to a third embodiment mode of the present invention will be described with reference to FIG. 36 to FIG. 47.

### <Structure>

FIG. 36 is a perspective view showing the multilayer printed board according to the third embodiment mode of the present invention.

As shown in FIG. 36, the BC layer in the multilayer printed board according to this embodiment mode becomes a circle as compared with that shown in the first embodiment mode (FIG. 1 and the like) or the second embodiment mode (FIG. 14) (This is referred to as the circular BC layer 16). That is, a metallic thin film (copper thin film) composing each of a power supply layer 13 and a ground layer 15 becomes a circle.

On the other hand, other constituent elements of the multilayer printed board according to this embodiment mode are identical to those in the case of the first embodiment mode or the second embodiment mode. Therefore, the same references are provided for the same constituent elements and thus the descriptions are omitted here.

In FIG. 36, the thin film dielectric 4 has the same shape as that shown in the first embodiment mode (FIG. 1 and the like) or the second embodiment mode (FIG. 12). Instead of such a shape, the thin film dielectric 4 may be formed in the same circular shape as that of the power supply layer 13 or the ground layer 15.

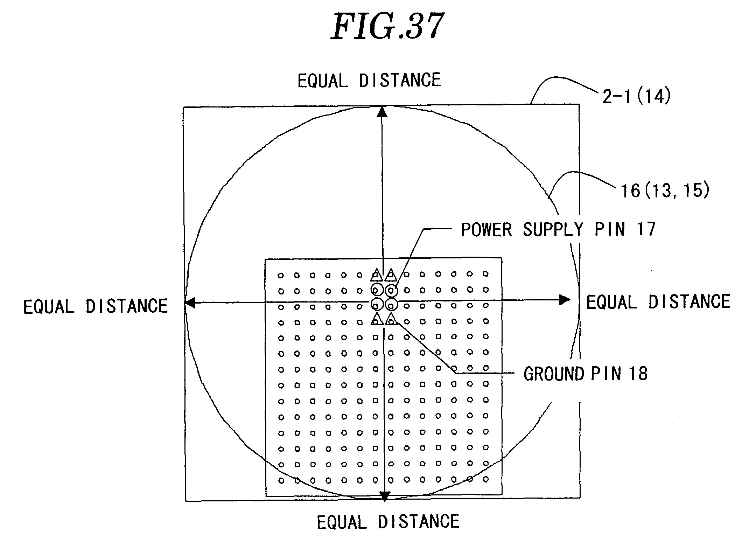

FIG. 37 is a plan view as viewed from a direction indicated by an arrow G in FIG. 36. As shown in FIG. 37, in the multilayer printed board according to this embodiment mode, the power supply pin 17 of the LSI 1 is located to the position where the central axis of the BC layer 16 (power supply layer 13 and ground layer 15) passes through.

For example, the power supply via may be formed perpendicular to the board surface at the position of the power supply pin 17 so that the power supply via passes through the central axis of the BC layer 16. In FIG. 37, the ground pin 18 of the LSI 1 is located close to the power supply pin 17.

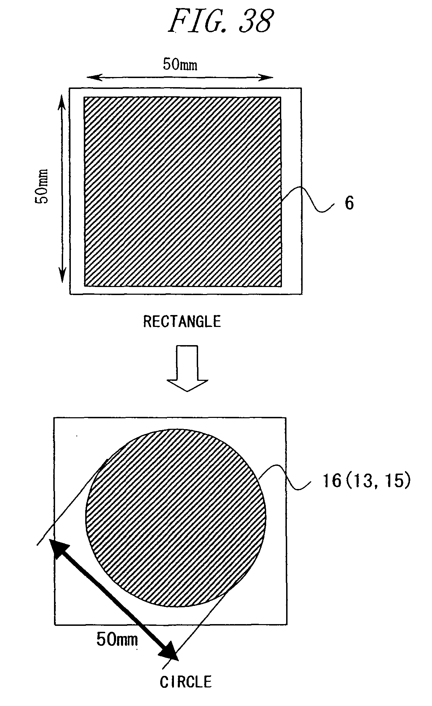

According to such a structure, a distance between the power supply via and each of the peripheral portions of the BC layer 16 (peripheral portion of the copper thin film composing the power supply layer 13 and the peripheral portion of the copper thin film composing the ground layer 15) can be adjusted to an equal distance on the BC layer 16. FIG. 38 shows comparison between the BC layer 16 and the BC layer 6 in the first embodiment mode or the second embodiment mode.

In the second embodiment mode, the BC layer is formed in the rectangular shape of 50 mm (or 25 mm) square. On the other hand, in this embodiment mode, a copper thin film having a diameter of 50 mm is used for the power supply layer 13 and the ground layer 15 in order to form the circular BC layer 16.

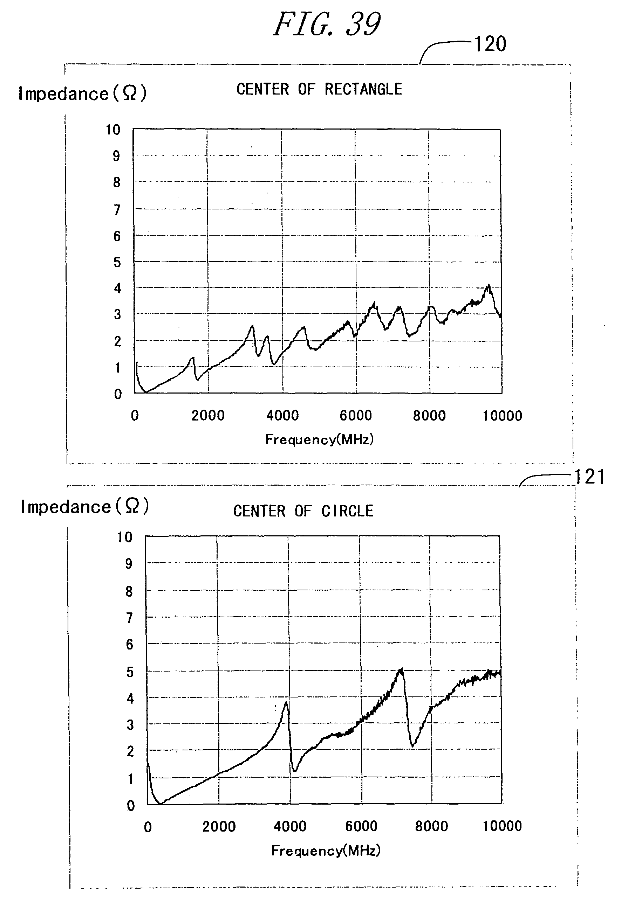

FIG. 39 shows analytical results of impedance in the case where the power supply via is located close to the central axis of the BC layer which is the rectangle of 50 mm square as used in the second embodiment mode and in the case where the power supply via is located close to the central axis of the circular BC layer 16 having the diameter of 50 mm. The analytical procedure and the analytical condition are identical to those in the second embodiment mode. That is, the wave source is set between the power supply layer and the ground layer.

A graph 120 shows a frequency characteristic of an impedance between the power supply layer 3 and the ground layer 5 in the case where the power supply via (and the wave source located just thereunder) is located close to the central axis of the BC layer which is the rectangle of 50 mm square as used in the second embodiment mode. As described in the second embodiment mode, when the power supply via is located close to the center of the rectangular BC layer 6 (power supply pin 17 of the LSI 1 is located close to the central axis of the BC layer 6 on the signal layer), a natural resonance mode can be suppressed and a peak impedance value at the time of natural resonance can be reduced.

When the circular BC layer 16 in this embodiment mode is employed and the power supply via is located close to the central axis thereof, as shown in the graph 121, the natural resonance mode can be further suppressed as compared with the case of the rectangle. For example, in the case of the graph 121 of FIG. 39, only two resonance points are present in the vicinities of 4000 MHz and 7100 MHz.

It may be the result of reduction of combinations of resonance modes, which is brought by a distance up to the peripheral portion of the circular BC layer 16 becoming substantially equal as viewed from the center of the circular BC layer 16.

### <Modified Example>

The third embodiment mode shows that, when the circular BC layer 16 is employed and the power supply via is located close to the central axis of the circular BC layer 16, it is possible to suppress the resonance mode. That is, the power supply pin 17 of an IC having a highest operating frequency is located close to the axis passing through the center of the circular BC layer 16 to reduce the natural resonance mode of the BC layer.

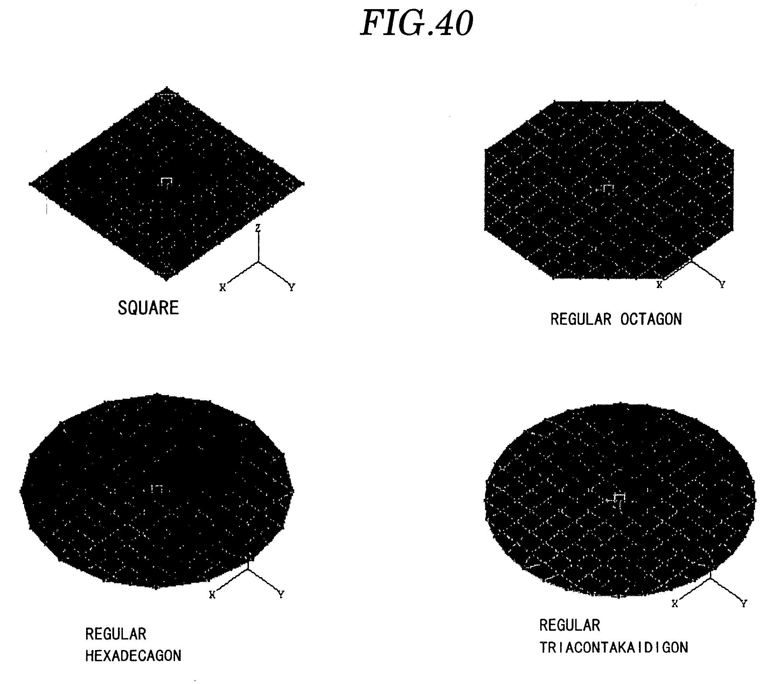

However, the embodiment of the present invention is not limited to such a structure. For example, as shown in FIG. 40, the BC layer may be formed in a flat shape of a regular polygon other than a square, such as a regular octagon, a regular hexadecagon, or a regular triacontakaidigon.

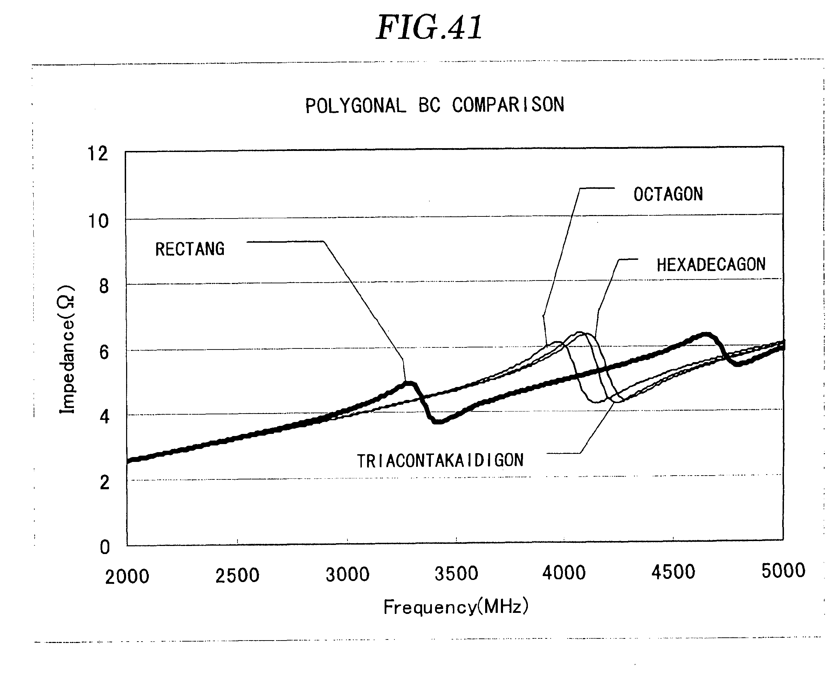

FIG. 41 is a graph obtained by plotting a frequency characteristic of an impedance between the power supply layer and the ground layer in the BC layer having the flat shape of the square, the regular octagon, the regular hexadecagon, or the regular triacontakaidigon.

In FIG. 41, the rectangle indicates the case where the BC layer is a rectangle of 50 mm square. The octagon, the hexadecagon, or the triacontakaidigon indicates the case where the BC layer is a regular polygon. In such a case, a length of a diagonal line of each of the regular octagon, the regular hexadecagon, and the regular triacontakaidigon is set to 50 mm.

As is apparent from FIG. 41, the resonance in a low frequency domain is suppressed as the polygon is changed from the rectangle to the regular octagon, the regular hexadecagon, or the regular triacontakaidigon (respectively indicated by the octagon, the hexadecagon, or the triacontakaidigon in FIG. 41), so that the resonance position is present on the high frequency side. In FIG. 41, the reason why the resonance position in the regular hexadecagon is present on the high frequency domain side than that in the regular triacontakaidigon may be an analytical error caused by modeling.

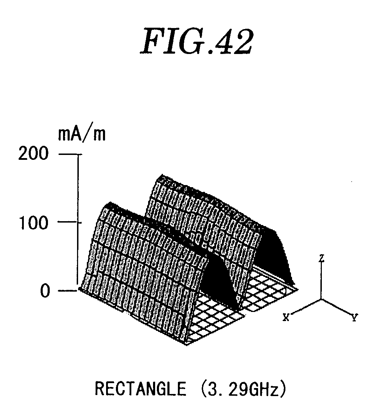

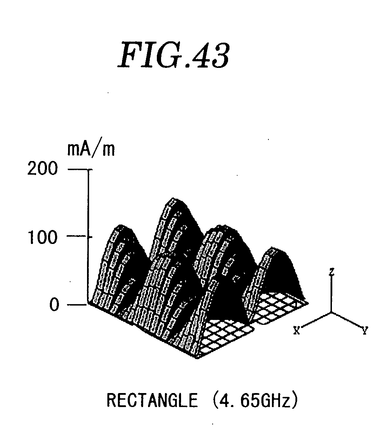

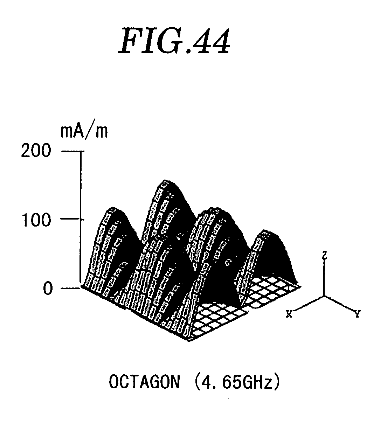

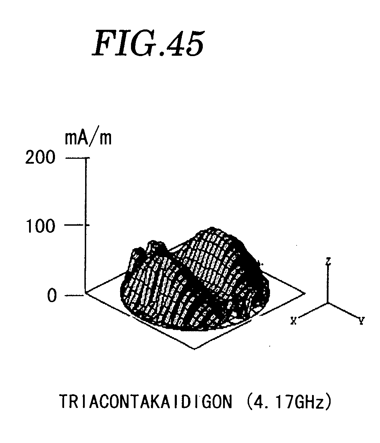

FIGS. 42 and 43 show analytical results of current densities in the rectangular BC layer in the vicinities of the resonance points. FIGS. 44 and 45 show analytical results of current densities in the regular octagonal BC layer and the regular triacontakaidigonal BC layer at the time of resonance. In each of those results, the same high frequency voltage as that in the second embodiment mode is supplied to obtain a current density distribution.

FIG. 42 shows a current distribution in the rectangular BC layer, which is caused by a high frequency current of 3.29 GHz. This is a current distribution in the vicinity of a resonance point present on a low frequency domain side in the rectangle shown in FIG. 41 (left side in FIG. 41). FIG. 43 shows a current distribution in the rectangular BC layer, which is caused by a high frequency current of 4.65 GHz. This is a current distribution in the vicinity of a resonance point present on a high frequency domain side in the rectangle shown in FIG. 41 (right side in FIG. 41).

FIG. 44 shows a current distribution in the octagonal BC layer, which is caused by a high frequency current of 4.65 GHz. FIG. 45 shows a current distribution in the triacontakaidigonal BC layer, which is caused by the high frequency current of 4.65 GHz.

As is apparent from FIGS. 42 to 45, the current densities in the regular octagonal BC layer and the regular triacontakaidigonal BC layer reduce as compared with the rectangular BC layer. Note that the case of the regular hexadecagonal BC layer is similar to the case of the regular triacontakaidigonal BC layer (not shown here).

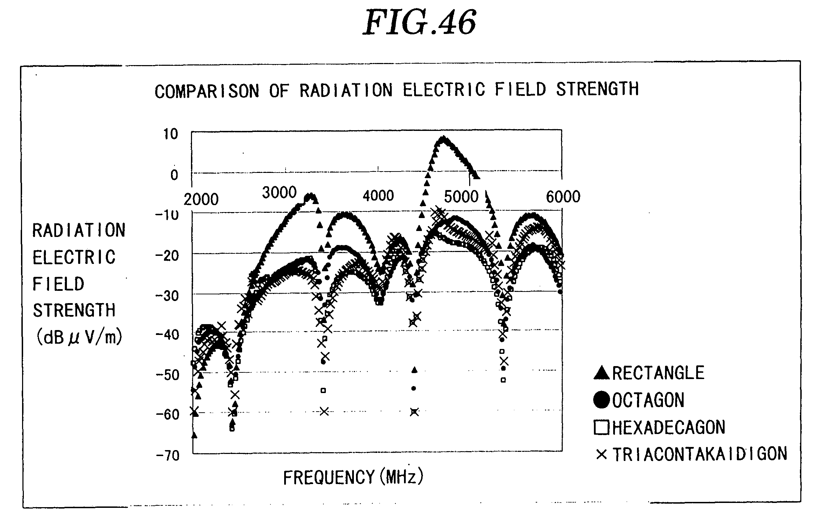

FIG. 46 shows analytical results of radiation electric field strengths in the rectangular BC layer, the regular octagonal BC layer, the regular hexadecagonal BC layer, and the regular triacontakaidigonal BC layer at the time of resonance. The analytical condition and the measurement condition are identical to those in the second embodiment mode (FIGS. 26, 27, 29, and 30).

As shown in FIG. 46, in the case of the rectangular BC layer, the radiation electric field strength becomes stronger in the vicinities of resonance points (such as the vicinities of 3300 MHz and 4800 MHz). On the other hand, the radiation electric field strengths in the regular octagonal BC layer, the regular hexadecagonal BC layer, and the regular triacontakaidigonal BC layer can be suppressed as compared with that in the rectangular BC layer.

When the above-mentioned results are generalized, the flat shape of the BC layer is made such that a ratio Lmax/Lmin between maximal values Lmax and minimal values Lmin of a distance between the center of the BC layer and the peripheral portion of the BC layer becomes 1 to 1.41. Therefore, the resonance mode can be reduced to reduce the radiation electric field strength. For example, a conductor thin film composing the power supply layer and the ground layer (or at least one of those) may be formed such that the ratio Lmax/Lmin between the maximal values Lmax and minimal values Lmin of a distance between the center of the conductor thin film and the peripheral portion thereof becomes 1 to 1.41.

For example, in the case of the square, the ratio between maximal and minimal values of a distance between the center and the peripheral portion is 1.41421356. In the case of circle, the ratio between maximal and minimal values of a distance between the center and the peripheral portion is 1.

### <<Fourth Embodiment Mode>>

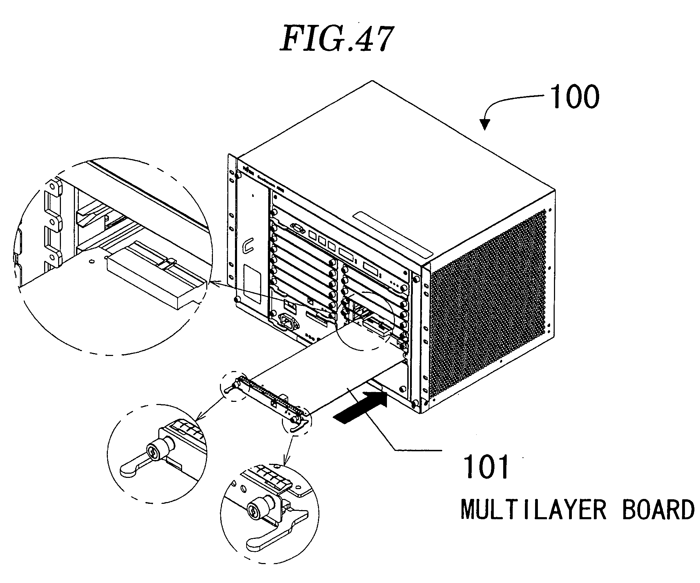

Hereinafter, the electronic apparatus 100 according to a fourth embodiment mode of the present invention will be described with reference to the drawing of FIG. 47. The electronic apparatus 100 is, for example, a communication apparatus such as a router or a packet switching device or an information process ing apparatus such as a computer main body. The feature of the electronic apparatus 100 is to include any one of the multilayer boards (multilayer board 101 in FIG. 47) as described in the first embodiment mode to the third embodiment mode in its case and mount the above-mentioned element thereon.

Therefore, when the multilayer board 101 is constructed to connect between the plurality of BC layers 6 as described in the first embodiment mode, the impedance between the power supply layer 3 and the ground layer 5 in a low frequency domain (for example, up to the first resonance point) can be reduced. In such a case, when the plurality of power supply vias 7 or the plurality of ground vias 8 are provided, the resonance frequency can be shifted to the high frequency domain, with result that it is possible to widen the operating frequency band.

When the power supply pin of a high-speed (for example, the operating frequency is 1 GHz or more) element is located close to the central axis of the BC layer in the multilayer board 101 as described in the second embodiment mode, the resonance mode can be reduced to reduce the radiation electric field strength.

In the multilayer board 101, as described in the third embodiment mode, the BC layer is formed in a shape of regular polygon having sides whose number is equal to or larger than five and the power supply pin of a highest-speed element is located close to the central axis of the BC layer. Therefore, the resonance mode can be further reduced to reduce the radiation electric field strength.

Thus, when the multilayer printed board including any of the BC layers 6 described in the first embodiment mode to the third embodiment mode is introduced into the electronic apparatus, unnecessary resonance can be prevented to ensure stable operation. In addition, it is possible to increase the degree of freedom for designing the stable electronic apparatus.

### INDUSTRIAL APPLICABILITY

The present invention can be used for an industry in which a printed board is manufactured and an industry in which an electronic apparatus including the printed board is manufactured.

## Claims

1. A multilayer printed board, comprising:
a plurality of capacitive coupling layers, each of which includes a power supply layer and a ground layer which are opposed to each other and a dielectric layer which is sandwiched therebetween;
a first via that connects between the power supply layers included in the plurality of capacitive coupling layers; and
a second via that connects between the ground layers included in the plurality of capacitive coupling layers.

2. A multilayer printed board, wherein the number of at least one of the first via and the second via is two or more.

3. A multilayer printed board according to claim 1, wherein the power supply layer and the ground layer in each of the plurality of capacitive coupling layers are laminated in the same arrangement order.

4. A multilayer printed board according to claim 1, wherein the power supply layer and the ground layer in a first capacitive coupling layer of the plurality of capacitive coupling layers are laminated in an arrangement order reverse to an arrangement order of the power supply layer and the ground layer in a second capacitive coupling layer thereof.

5. A multilayer printed board according to claim 1, wherein the power supply layer and the ground layer form a capacitive coupling layer over an entire region of the dielectric layer.

6. A multilayer printed board according to claim 1, wherein the power supply layer and the ground layer form a capacitive coupling layer in a partial region of the dielectric layer.

7. A multilayer printed board according to claim 5 or 6, wherein a power supply via that connects a power supply terminal of an element with the power supply layer is formed close to a central axis passing through substantially a central portion of a flat region of the capacitive coupling layer.

8. A multilayer printed board according to any one of claims 5 to 7, wherein a flat shape of at least one of the power supply layer and the ground layer is substantially a regular polygon having sides whose number is equal to or larger than five.

9. A multilayer printed board according to any one of claims 5 to 7, wherein a flat shape of at least one of the power supply layer and the ground layer is substantially a circle.

10. A multilayer printed board according to any one of claims 5 to 7, wherein a ratio of a longest distance to a shortest distance between a central portion and a peripheral portion of a flat shape of at least one of the power supply layer and the ground layer thereof is 1 to 1.41.

11. A multilayer printed board, comprising:
a capacitive coupling layer that includes a power supply layer and a ground layer which are opposed to each other and a dielectric layer which is sandwiched therebetween;
an element layer on which an element to which power is supplied from the power supply layer is mounted; and
a via that is formed close to a central axis passing through substantially a central portion of a flat region of the capacitive coupling layer and connects a power supply terminal of the element with the power supply layer.

12. A multilayer printed board according to claim 11, wherein the power supply layer and the ground layer form a capacitive coupling layer over an entire region of the dielectric layer.

13. A multilayer printed board according to claim 11 , wherein the power supply layer and the ground layer form a capacitive coupling layer in a partial region of the dielectric layer.

14. A multilayer printed board according to any one of claims 11 to 13, wherein a flat shape of at least one of the power supply layer and the ground layer is substantially a regular polygon having sides whose number is equal to or larger than five.

15. A multilayer printed board according to any one of claims 11 to 13, wherein a flat shape of at least one of the power supply layer and the ground layer is substantially a circle.

16. A multilayer printed board according to any one of claims 11 to 13, wherein a ratio of a longest distance to a shortest distance between a central portion and a peripheral portion of a flat shape of at least one of the power supply layer and the ground layer thereof is 1 to 1.41.

17. An electronic apparatus in which a multilayer printed board is provided, the multilayer printed board comprising:
a plurality of capacitive coupling layers, each of which includes a power supply layer and a ground layer which are opposed to each other and a dielectric layer which is sandwiched therebetween;
a first via that connects between the power supply layers included in the plurality of capacitive coupling layers; and
a second via that connects between the ground layers included in the plurality of capacitive coupling layers.

18. An electronic apparatus in which a multilayer printed board is provided, the multilayer printed board comprising:
a capacitive coupling layer that includes a power supply layer and a ground layer which are opposed to each other and a dielectric layer which is sandwiched therebetween;
an element layer on which an element to which power is supplied from the power supply layer is mounted; and
a via that is formed close to a central axis passing through substantially a central portion of a flat region of the capacitive coupling layer and connects a power supply terminal of the element with the power supply layer.

19. A method of packaging an electronic apparatus, comprising:
a step producing a plurality of capacitive coupling layers, each of which includes a power supply layer and a ground layer which are opposed to each other and a dielectric layer which is sandwiched therebetween;
a first via connecting step connecting between the power supply layers included in the plurality of capacitive coupling layers through a first via; and
a second via connecting step connecting between the ground layers included in the plurality of capacitive coupling layers through a second via.

20. A method of packaging an electronic apparatus according to claim 19, wherein at least one of the first via connecting step and the second via connecting step is executed plural times and at least one of the power supply layer and the ground layer is connected at a plurality of portions.

21. A method of packaging an electronic apparatus according to claim 19 or 20, wherein in the step producing, the power supply layer and the ground layer in each of the plurality of capacitive coupling layers are laminated in the same arrangement order.

22. A method of packaging an electronic apparatus according to claim 19 or 20, wherein in the step producing, the power supply layer and the ground layer in a first capacitive coupling layer of the plurality of capacitive coupling layers are laminated in an arrangement order reverse to an arrangement order of the power supply layer and the ground layer in a second capacitive coupling layer thereof.

23. A method of packaging an electronic apparatus according to any one of claims 19 to 22, wherein in the step producing, each of the capacitive coupling layers is formed over an entire region of the dielectric layer therein.

24. A method of packaging an electronic apparatus according to any one of claims 19 to 22, wherein in the step producing, each of the capacitive coupling layers is formed in a partial region of the dielectric layer therein.

25. A method of packaging an electronic apparatus according to any one of claims 19 to 24, further comprising the step forming a power supply via that connects a power supply terminal of an element with the power supply layer at a vicinity of a central axis passing through substantially a central portion of a flat region of the capacitive coupling layer.

26. A method of packaging an electronic apparatus according to any one of claims 19 to 25, wherein a flat shape of at least one of the power supply layer and the ground layer is substantially a regular polygon having sides whose number is equal to or larger than five.

27. A method of packaging an electronic apparatus according to any one of claims 19 to 25, wherein a flat shape of at least one of the power supply layer and the ground layer is substantially a circle.

28. A method of packaging an electronic apparatus according to any one of claims 19 to 25, wherein a ratio of a longest distance to a shortest distance between a central portion and a peripheral portion of a flat shape of at least one of the power supply layer and the ground layer thereof is 1 to 1.41.

29. A method of packaging an electronic apparatus, comprising:
a capacitive coupling step forming a capacitive coupling layer that includes a power supply layer and a ground layer which are opposed to each other and a dielectric layer which is sandwiched therebetween;
a step forming an element layer on which an element to which power is supplied from the power supply layer is mounted; and
a step forming a via that connects a power supply terminal of the element with the power supply layer at a vicinity of a central axis passing through substantially a central portion of a flat region of the capacitive coupling layer.

30. A method of packaging an electronic apparatus according to claim 29, wherein in the capacitive coupling step, the capacitive
coupling layer is formed over an entire region of a printed board.

31. A method of packaging an electronic apparatus according to claim 29, wherein in the capacitive coupling step, the capacitive coupling layer is formed in a partial region of a printed board.

32. A method of packaging an electronic apparatus according to any one of claims 29 to 31, wherein in the capacitive coupling step, a flat shape of at least one of the power supply layer and the ground layer is formed into substantially a regular polygon having sides whose number is equal to or larger than five.

33. A method of packaging an electronic apparatus according to any one of claims 29 to 31, wherein in the capacitive coupling step, a flat shape of at least one of the power supply layer and the ground layer is formed into substantially a circle.

34. A method of packaging an electronic apparatus according to any one of claims 29 to 31, wherein in the capacitive coupling step, a ratio of a longest distance to a shortest distance between a central portion and a peripheral portion of a flat shape of at least one of the power supply layer and the ground layer thereof is 1 to 1.41.
